(19) **Europäisches Patentamt / European Patent Office / Office européen des brevets**

(11) **EP 2 977 475 B1**

(12) **EUROPEAN PATENT SPECIFICATION**

(45) Date of publication and mention
of the grant of the patent:
**10.10.2018 Bulletin 2018/41**

(21) Application number: **13878640.5**

(22) Date of filing: **29.08.2013**

(51) Int Cl.:
*C22C 9/04* (2006.01)          *C22F 1/08* (2006.01)
*H01B 1/02* (2006.01)          *H01L 23/48* (2006.01)
*H01L 23/495* (2006.01)       *H01L 23/50* (2006.01)

(86) International application number:
**PCT/JP2013/073213**

(87) International publication number:
**WO 2014/147862 (25.09.2014 Gazette 2014/39)**

(54) **COPPER ALLOY FOR ELECTRICAL AND ELECTRONIC EQUIPMENT, COPPER ALLOY THIN SHEET FOR ELECTRICAL AND ELECTRONIC EQUIPMENT, AND CONDUCTIVE COMPONENT AND TERMINAL FOR ELECTRICAL AND ELECTRONIC EQUIPMENT**

KUPFERLEGIERUNG FÜR ELEKTRISCHE UND ELEKTRONISCHE VORRICHTUNGEN, KUPFERLEGIERUNGSDÜNNSCHICHT FÜR ELEKTRISCHE UND ELEKTRONISCHE VORRICHTUNGEN SOWIE LEITFÄHIGES TEIL UND KLEMME FÜR ELEKTRISCHE UND ELEKTRONISCHE VORRICHTUNGEN

ALLIAGE DE CUIVRE POUR ÉQUIPEMENT ÉLECTRIQUE ET ÉLECTRONIQUE, FEUILLE MINCE D'ALLIAGE DE CUIVRE POUR ÉQUIPEMENT ÉLECTRIQUE ET ÉLECTRONIQUE, ET COMPOSANT CONDUCTEUR ET BORNE POUR ÉQUIPEMENT ÉLECTRIQUE ET ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.03.2013 JP 2013055076**

(43) Date of publication of application:
**27.01.2016 Bulletin 2016/04**

(73) Proprietors:
• **Mitsubishi Materials Corporation**
  **Chiyoda-ku**
  **Tokyo 100-8117 (JP)**
• **Mitsubishi Shindoh Co., Ltd.**
  **Tokyo 140-8550 (JP)**

(72) Inventors:
• **MAKI Kazunari**
  **Kitamoto-shi**
  **Saitama 364-0022 (JP)**
• **MORI Hiroyuki**
  **Kitamoto-shi**
  **Saitama 364-0022 (JP)**

• **YAMASHITA Daiki**
  **Kitamoto-shi**
  **Saitama 364-0022 (JP)**

(74) Representative: **Hoffmann Eitle**
**Patent- und Rechtsanwälte PartmbB**
**Arabellastraße 30**
**81925 München (DE)**

(56) References cited:
**WO-A1-2012/096237      WO-A1-2013/039207**
**JP-A- 2005 060 773      JP-A- 2007 084 920**
**JP-A- 2012 122 095      JP-B1- 5 303 678**
**US-B1- 6 471 792**

• **ANDRADE J M ET AL: "Classical univariate calibration and partial least squares for quantitative analysis of brass samples by laser-induced breakdown spectroscopy", SPECTROCHIMICA ACTA. PART B: ATOMIC SPECTROSCOPY, NEW YORK, NY, US, US, vol. 65, no. 8, 24 April 2010 (2010-04-24) , pages 658-663, XP027144315, ISSN: 0584-8547 [retrieved on 2010-04-24]**

**Description**

TECHNICAL FIELD

The present invention relates to a Cu-Zn-Sn-based copper alloy for an electric and electronic device, a copper alloy sheet for an electric and electronic device, a conductive component for an electric and electronic device, and a terminal using the same, the copper alloy being used as a conductive component for an electric and electronic device such as a connector of a semiconductor device, other terminals thereof, a movable contact of an electromagnetic relay, or a lead frame.

Priority is claimed on Japanese Patent Application No. 2013-055076, filed March 18, 2013.

BACKGROUND ART

As a material of a conductive component for an electric and electronic device, a Cu-Zn alloy is widely used in the related art from the viewpoint of, for example, balance between strength, workability, and cost.

In addition, in the case of a terminal such as a connector, in order to improve reliability of contact with an opposite-side conductive member, a surface of a substrate (blank) formed of a Cu-Zn alloy is plated with tin (Sn). In a conductive component such as a connector obtained by plating a surface of a Cu-Zn alloy as a substrate with Sn, a Cu-Zn-Sn-based alloy in which Sn added to the Cu-Zn alloy may be used in order to improve the recycling efficiency of the Sn-plated substrate and the strength.

Typically, a conductive component for an electric and electronic device such as a connector is manufactured by punching a sheet (rolled sheet) having a thickness of about 0.05 mm to 1.0 mm into a predetermined shape and bending at least a portion of the sheet. In this case, a peripheral portion around the bent portion of conductive component is brought into contact with an opposite-side conductive member so as to obtain an electric connection with the opposite-side conductive member, and due to the spring properties of the bent portion, the contact state with the opposite-side conductive member is maintained.

It is preferable that a copper alloy for an electric and electronic device used for a conductive component for an electric and electronic device is superior in conductivity, rellability, and punchability. Further, as described above, in the case of the copper alloy for the connector or the like in which the contact state between the peripheral portion around the bent portion and the opposite-side conductive member is maintained due to the spring properties of the bent portion obtained by bending, bendability and stress relaxation resistance of the copper alloy are required to be superior.

For example, Patent Documents 1 to 3 disclose methods for improving the stress relaxation resistance of a Cu-Zn-Sn-based alloy.

Patent Document 1 describes that stress relaxation resistance of the copper alloy can be improved by adding Ni to a Cu-Zn-Sn-based alloy to produce a Ni-P compound. In addition, Patent Document 1 describes that the addition of Fe is also efficient for improvement of stress relaxation resistance of the copper alloy.

Patent Document 2 describes that strength, elasticity, and heat resistance can be improved by adding Ni and Fe to a Cu-Zn-Sn-based alloy together with P to produce a compound. The above-described improvement of strength, elasticity, and heat resistance implies improvement of stress relaxation resistance of the copper alloy.

In addition, Patent Document 3 describes that stress relaxation resistance of the copper alloy can be improved by adding Ni to a Cu-Zn-Sn-based alloy and adjusting a Ni/Sn ratio to be in a specific range. In addition, Patent Document 3 describes that the addition of a small amount of Fe is also efficient for improving stress relaxation resistance of the copper alloy.

Further, Patent Document 4 targeted for a lead frame material describes that stress relaxation resistance of the copper alloy can be improved by adding Ni and Fe to a Cu-Zn-Sn-based alloy together with P, adjusting an atomic ratio (Fe+Ni)/P to be in a range of 0.2 to 3, and producing a Fe-P-based compound, a Ni-P-based compound, and a Fe-Ni-P-based compound.

Patent Document 5 describes a brass alloy, consisting, by weight, of from 2% to the maximum that maintains an alpha brass microstructure of zinc; from 0.2% to 2% nickel; from 0.15% to 1% tin; from 0.033% to 0.2% phosphorous; optional from 0.07% to 0.25% iron; from about 2 ppm to about 50 ppm of oxygen, sulfur, carbon or a mixture thereof; less than 2% in total of bismuth, lead, tellurium, sulfur and selenium; less than 0.25% each and 1% in total of magnesium, aluminum, silver, silicon, cadmium, manganese, cobalt, germanium, arsenic, gold, platinum, palladium, hafnium, zirconium, indium, antimony, chromium, vanadium and titanium; and the balance copper and inevitable impurities with a nickel:phosphorous weight ratio of between 4.5:1 and 9:1. The alloy can be used to form an electrical connector having a conductivity equal to or greater than 25% IACS and a resistance to stress relaxation at an operating temperature of at least 125°C.

Non-Patent Document 1 describes a comparison of the analytical results obtained by traditional calibration curves and multivariate partial least squares (PLS) algorithm when applied to the LIBS spectra obtained from ten brass samples.

Citation List

Patent Document

[Patent Document 1] Japanese Unexamined Patent Application, First Publication No. H5-33087 (A)
[Patent Document 2] Japanese Unexamined Patent Application, First Publication No. 2006-283060 (A)
[Patent Document 3] Japanese Patent No. 3953357 (B)
[Patent Document 4] Japanese Patent No. 3717321 (B)
[Patent Document 5] US 6 471 792 B1
[Non-Patent Document 1] J. M. Andrade, et. al., Spectrochimica Acta. Part B, Vol. 65, No. 8, pages 658 to 663 (2010)

DISCLOSURE OF INVENTION

Technical Problem

However, Patent Documents 1 and 2 consider only each content of Ni, Fe, and P, and the adjustment of each content cannot necessarily realize reliable and sufficient improvement of stress relaxation resistance of the copper alloy.
In addition, Patent Document 3 discloses the adjustment of the Ni/Sn ratio but does not consider a relationship between a P compound and stress relaxation resistance at all. Therefore, sufficient and reliable improvement of stress relaxation resistance of the copper alloy cannot be realized.
Further, Patent Document 4 only describes the adjustment of the total content of Fe, Ni, and P and the adjustment of the atomic ratio of (Fe+Ni)/P and cannot realize sufficient improvement of stress relaxation resistance of the copper alloy.
As described above, with the methods disclosed in the related art, the stress relaxation resistance of a Cu-Zn-Sn-based alloy cannot be sufficiently improved. Therefore, in a connector or the like having the above-described structure, residual stress is relaxed over time or in a high-temperature environment, and contact pressure with an opposite-side conductive member is not maintained. As a result, there is a problem in that a problem such as contact failure is likely to occur in the early stages. In order to avoid such a problem, in the related art, the thickness of a material is inevitably increased, which causes an increase in material cost and weight.
Therefore, more reliable and sufficient improvement in stress relaxation resistance of the copper alloy is strongly desired.
The present invention is made under the above-described circumstances and an object thereof is to provide a copper alloy for an electric and electronic device, a copper alloy sheet for an electric and electronic device using the same, a conductive component for an electric and electronic device and a terminal, the copper alloy having excellent stress relaxation resistance; and excellent strength and bendability.

Solution to Problem

As a result of extensive experiments and research, the inventors have obtained the following findings. Appropriate amounts of Ni and Fe are added and an appropriate amount of P is added to the Cu-Zn-Sn-based alloy, and a ratio Fe/Ni of a Fe content to a Ni content, a ratio (Ni+Fe)/P of a total content (Ni+Fe) of Ni and Fe to a P content, and a ratio Sn/(Ni+Fe) of a Sn content to a total content (Ni+Fe) of Ni and Fe are controlled to be in appropriate ranges by atomic ratio, thereby, appropriately precipitating precipitates containing Fe and/or Ni and P. In addition to that, the special grain boundary length ratio (L$\sigma$/L), which is the ratio of the sum of each grain boundary length of: $\Sigma$3; $\Sigma$9; $\Sigma$27a; and $\Sigma$27b special grain boundaries to the length of all crystal grain boundaries measured by the EBSD method in the matrix (mainly $\alpha$ phase), is appropriately controlled. Thus, it is possible to obtain a copper alloy having reliably and sufficiently improved stress relaxation resistance, and excellent strength and bendability.
Further, the inventors have found that the stress relaxation resistance and strength of the copper alloy could be further improved by adding an appropriate amount of Co with the above-described Ni and/or Fe, and P.
According to a first aspect of the present invention, there is provided a copper alloy for an electric and electronic device, the copper alloy including: Zn at higher than 2 mass% and lower than 23 mass%; Sn at 0.1 mass% or more and 0.9 mass% or less; Ni at 0.05 mass% or more and lower than 1.0 mass%; Fe at 0.001 mass% or more and 0.08 mass% or less; P at 0.005 mass% or more and 0.1 mass% or less; and the balance being Cu and unavoidable impurities, wherein a ratio Fe/Ni of a Fe content to a Ni content satisfies 0.002≤Fe/Ni<1.5 by atomic ratio, a ratio (Ni+Fe)/P of a total content (Ni+Fe) of Ni and Fe to a P content satisfies $3<(Ni+Fe)/P<15$ by atomic ratio, a ratio Sn/(Ni+Fe) of a Sn content to the total content (Ni+Fe) of Ni and Fe satisfies $0.3<Sn/(Ni+Fe)<5$ by atomic ratio, and a special grain boundary length ratio, $L\sigma/L$, is 10% or more, $L\sigma/L$ being a ratio of $L\sigma$ to L, $L\sigma$ being a sum of each grain boundary length of: $\Sigma3$; $\Sigma9$; $\Sigma27a$; and $\Sigma27b$ special grain boundaries in $\alpha$ phase crystal grains wherein the $\Sigma$ value is defined based on the CSL theory, and L being a length of all crystal grain boundaries in $\alpha$ phase crystal grains, in a case where an $\alpha$ phase containing Cu, Zn and Sn within a measurement area of $1000\mu m^2$ or larger is measured by EBSD method with a measurement interval of $0.1\mu m$ a step; data analysis is performed excluding measurement points with a CI (confidence index) value at 0.1 or less, the CI value being analyzed by a data analysis software OIM (orientation imaging microscopy); and a grain boundary is identified between adjacent measurement points with a misorientation exceeding 15°.

According to the copper alloy for an electric and electronic device having the above-described configuration, Ni and Fe are added thereto together with P, and addition ratios between Sn, Ni, Fe, and P are limited, and thereby an [Ni,Fe]-P-based precipitate containing Fe and/or Ni and P which is precipitated from a matrix (mainly composed of $\alpha$ phase) is present in an appropriate amount. As a result, stress relaxation resistance of the copper alloy is reliably and sufficiently superior, strength (yield strength) is high, and bendability is also superior.

In addition, by setting the special grain boundary length ratio ($L\sigma/L$) to 10% or more, the ratio of grain boundaries that turn into origins of the fracture during bending work can be reduced due to increase of the grain boundaries with high crystallinity (grain boundaries with less disturbance of the atomic arrangement). Accordingly, excellent bendability can be obtained.

Here, the [Ni,Fe]-P-based precipitate refers to a ternary precipitate of Ni-Fe-P or a binary precipitate of Fe-P or Ni-P, and may include a multi-component precipitate containing the above-described elements and other elements, for example, major components such as Cu, Zn, and Sn and impurities such as O, S, C, Co, Cr, Mo, Mn, Mg, Zr, and Ti. In addition, the [Ni,Fe]-P-based precipitate is present in the form of a phosphide or a solid-solution alloy containing phosphorus.

Here, the EBSD method means the electron backscatter diffraction patterns method using a scanning electron microscope with an electron backscattering image system.

In the EBSD method, electron beam is irradiated on the surface of the sample in the state where the surface is heavily tilted in the scanning electron microscope. The crystal orientation at the measurement point can be measured based on the crystal pattern (Kikuchi pattern) formed by the specular diffraction of the electron beam. The crystal pattern is obtained as multiple bands. Three bands are selected from the crystal pattern and a single or multiple solutions are calculated as the crystal orientation. Then, calculation is performed to the all combinations of three bands. Finally, among solutions calculated on each combination, the solution that is obtained most often as a whole is defined as the crystal orientation at the measurement point.

The OIM (Orientation Imaging Microscopy) is a data analysis software for analyzing the crystal orientation by using measurement data by the EBSD method. In this data analysis software OIM, the crystal grain is defined as gathering continuous measurement points with the same crystal orientation from the crystal orientations measured by EBSD method. By using the OIM software, information of the microstructure is constructed.

The CI value is a confidence index and the value output as the value indicating reliability of the determined crystal orientation during analysis using the analysis software OIM Analysis (Ver. 5.3) of the EBSD apparatus (for example, as explained in "EBSD Reader: Using OIM, 3rd Revised Edition" written by Seiichi Suzuki, September 2009, published by TSL Solutions Co., Ltd.). More specifically, weighting on each solution calculated during determination of a crystal orientation at a single measurement point by the EBSD method can be performed based on the number of appearance. In regard to the finally-determined reliability of the crystal orientation at the point, the value obtained based on the weighting is the CI value. In other words, when the crystal pattern is well-defined, a high CI value is obtained. When the crystal pattern is not well-defined, a low CI value is obtained. In the case where the structure at the measurement point, which is measured by EBSD and analyzed by the OIM, is a worked structure, the CI value is decreased since the crystal pattern is not well-defined and the reliability of the crystal orientation determination is decreased. Particularly, when the CI value is 0.1 or lower, it is determined that the structure at the measurement point is a worked structure.

The special grain boundary is the corresponding grain boundary: belonging to grain boundary with $3\leq\Sigma\leq29$ with $\Sigma$ value defined based on the CSL theory (Kronberg et al.: Trans. Met. Soc. AIME, 185, 501 (1949)) crystallographically; and satisfying $Dq\leq15°/\Sigma^{1/2}$ (D. G. Brandon: Acta. Metallurgica. Vol. 14, p. 1479, (1966)). Dq is a lattice orientation defect at a specific corresponding site in the above-mentioned corresponding grain boundary.

According to the second aspect of the present invention, there is provided a copper alloy for an electric and electronic device, the copper alloy including: Zn at higher than 2 mass% and lower than 23 mass%; Sn at 0.1 mass% or more and 0.9 mass% or less; Ni at 0.05 mass% or more and lower than 1.0 mass%; Fe at 0.001 mass% or more and 0.08 mass% or less; Co at 0.001 mass% or more and lower than 0.1 mass%; P at 0.005 mass% or more and 0.1 mass% or less; and the balance being Cu and unavoidable impurities, wherein a ratio (Fe+Co)/Ni of a total content of (Fe+Co) of Fe and Co to a Ni content satisfies $0.002\leq(Fe+Co)/Ni<1.5$ by atomic ratio, a ratio (Ni+Fe+Co)/P of a total content (Ni+Fe+Co) of Ni, Fe, and Co to a P content satisfies $3<(Ni+Fe+Co)/P<15$ by atomic ratio, a ratio Sn/(Ni+Fe+Co) of a Sn content to the total content (Ni+Fe+Co) of Ni, Fe, and Co satisfies 0.3<Sn/(Ni+Fe+Co)<5 by atomic ratio, and a special grain boundary length ratio, $L\sigma/L$, is 10% or more, $L\sigma/L$ being a ratio of $L\sigma$ to L, $L\sigma$ being a sum of each grain boundary length of: $\Sigma3$; $\Sigma9$; $\Sigma27a$; and $\Sigma27b$ special grain boundaries in $\alpha$ phase crystal grains wherein the $\Sigma$ value is defined based on the CSL theory, and L being a length of all crystal grain boundaries in $\alpha$ phase crystal grains, in a case where an $\alpha$ phase containing Cu, Zn and Sn within a measurement area of 1000 $\mu m^2$ or larger is measured by EBSD method with a measurement interval of 0.1 $\mu m$ a step; data analysis is performed excluding measurement points with a CI (confidence index) value at 0.1 or less, the CI value being analyzed by a data analysis software OIM (orientation imaging microscopy); and a grain boundary is identified between adjacent measurement points with a misorientation exceeding 15°.

The copper alloy according to the second aspect is the copper alloy according to the first aspect further including 0.001 mass% to less than 0.1 mass% of Co, in which the ratio (Fe+Co)/Ni of a total content of Fe and Co to a Ni content satisfies 0.002≤(Fe+Co)/Ni<1.5 by atomic ratio, the ratio (Ni+Fe+Co)/P of a total content (Ni+Fe+Co) of Ni, Fe, and Co to a P content satisfies 3<(Ni+Fe+Co)/P<15 by atomic ratio, and the ratio Sn/(Ni+Fe+Co) of a Sn content to the total content (Ni+Fe+Co) of Ni, Fe, and Co satisfies 0.3<Sn/(Ni+Fe+Co)<5 by atomic ratio.

According to the copper alloy for an electric and electronic device having the above-described configuration, Ni, Fe, and Co are added thereto together with P, and addition ratios between Sn, Ni, Fe, Co, and P are appropriately limited. As a result, an [Ni,Fe,Co]-P-based precipitate containing P and at least one element selected from Fe, Ni and Co which is precipitated from a matrix (mainly composed of $\alpha$ phase) is present in an appropriate amount. In addition to that, by setting the special grain boundary length ratio ($L\sigma/L$) to 10% or more, the ratio of grain boundaries that turn into origins of the fracture during bending work can be reduced due to increase of the grain boundaries with high crystallinity (grain boundaries with less disturbance of the atomic arrangement). Accordingly, excellent bendability can be obtained.

Here, the [Ni,Fe,Co]-P-based precipitate refers to a quaternary precipitate of Ni-Fe-Co-P, a ternary precipitate of Ni-Fe-P, Ni-Co-P, or Fe-Co-P, or a binary precipitate of Fe-P, Ni-P, or Co-P and may include a multi-component precipitate containing the above-described elements and other elements, for example, major components such as Cu, Zn, and Sn and impurities such as O, S, C, Co, Cr, Mo, Mn, Mg, Zr, and Ti. In addition, the [Ni,Fe,Co]-P-based precipitate is present in the form of a phosphide or a solid-solution alloy containing phosphorus.

The copper alloy according to the first or second aspect is a rolled material in which a surface (rolled surface) thereof may satisfy the above-described conditions of the special grain boundary length ratio ($L\sigma/L$) on the surface of the copper alloy. For example, the above-described rolled material may have a form of a sheet or a strip and the surface of the sheet or the strip may satisfy the above-described conditions of the special grain boundary length ratio ($L\sigma/L$) on the surface of the copper alloy.

In the copper alloy for an electric and electronic device according to the first or second aspect, it is preferable that the average crystal grain size, including twinned crystals, of the $\alpha$ phase containing Cu, Zn and Sn is in a range of 0.5 $\mu m$ or more and 10 $\mu m$ or less.

By having the average crystal grain size, including twinned crystals, of the $\alpha$ phase containing Cu, Zn and Sn being in a range of 0.5 $\mu m$ or more and 10 $\mu m$ or less in this manner, sufficient strength (yield strength) can be obtained while keeping the stress relaxation resistance of the copper alloy.

In the copper alloy for an electric and electronic device according to the first or second aspect, it is preferable that the copper alloy has mechanical properties including a 0.2% yield strength of 300 MPa or higher.

The copper alloy for an electric and electronic device, which has mechanical properties including the 0.2% yield strength of 300 MPa or higher, is suitable for a conductive component in which high strength is particularly required, for example, a movable contact of an electromagnetic relay or a spring portion of a terminal.

According to the third aspect of the present invention, there is provided a copper alloy sheet for an electric and electronic device including: a sheet main body made of a rolled material formed of the copper alloy for an electric and electronic device according to the first or second aspect, in which a thickness of the sheet main body is in a range of 0.05 mm to 1.0 mm. Note that, the copper alloy sheet main body may be a sheet (tape-shaped copper alloy) having a strip form.

The copper alloy sheet for an electric and electronic device having the above-described configuration can be suitably used for a connector, other terminals, a movable contact of an electromagnetic relay, or a lead frame.

In the copper alloy sheet for an electric and electronic device according to the third aspect of the present invention, Sn may be plated on the surface of the copper alloy sheet.

In this case, a substrate to be plated with Sn is formed of a Cu-Zn-Sn-based alloy containing 0.1 mass% to 0.9 mass% of Sn. Therefore, a component such as a connector after use can be collected as scrap of a Sn-plated Cu-Zn alloy, and superior recycling efficiency can be secured.

According to the fourth aspect of the present invention, there is provided a conductive component for an electric and electronic device including the copper alloy for an electric and electronic device according to the first or second aspect.

In addition, according to the fifth aspect of the present invention, there is provided a terminal including the copper alloy for an electric and electronic device according to the first or second aspect.

In the conductive component for an electric and electronic device according to the fourth aspect of the present invention, the conductive component may include the copper alloy sheet for an electric and electronic device according to the third aspect.

In the terminal according to the fifth aspect of the present invention, the terminal may include the copper alloy sheet for an electric and electronic device according to the third aspect.

According to the conductive component for an electric and electronic device and the terminal having the above-described configurations, stress relaxation resistance of the copper alloy is particularly superior. Therefore, residual stress is not likely to be relaxed over time or in a high-temperature environment and the contact pressure with the opposite-side conductive member can be maintained. In addition, the thickness of the conductive component for an electric and electronic device and terminal can be reduced.

Advantageous Effects of Invention

According to the present invention, it is possible to provide a copper alloy for an electric and electronic device, a copper alloy sheet for an electric and electronic device, a conductive component for an electric and electronic device, and a terminal using the same, in which the copper alloy has reliably and sufficiently excellent stress relaxation resistance; and excellent strength and bendability.

BRIEF DESCRIPTION OF THE DRAWING

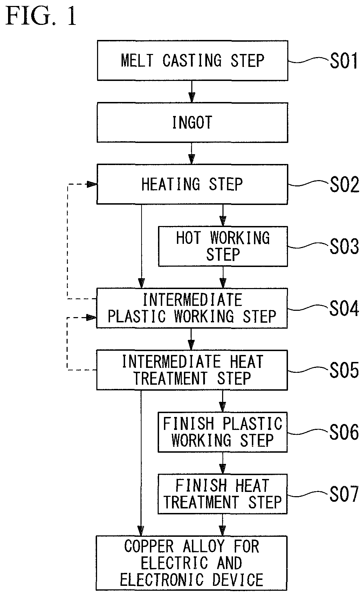

FIG. 1 is a flow chart showing a process example of a method of producing a copper alloy for an electric and electronic device according to the present invention.

DESCRIPTION OF EMBODIMENTS

Hereinafter, a copper alloy for an electric and electronic device according to an embodiment of the present invention will be described.

The copper alloy for an electric and electronic device according to the embodiment has a composition comprising: Zn at higher than 2 mass% and lower than 23 mass%; Sn at 0.1 mass% or more and 0.9 mass% or less; Ni at 0.05 mass% or more and lower than 1.0 mass%; Fe at 0.001 mass% or more and 0.08 mass% or less; P at 0.005 mass% or more and 0.1 mass% or less; and the balance being Cu and unavoidable impurities.

Content ratios between the respective alloy elements are determined such that a ratio Fe/Ni of a Fe content to a Ni content satisfies the following Expression (1) of $0.002 \leq Fe/Ni < 1.5$ by atomic ratio, a ratio (Ni+Fe)/P of a total content (Ni+Fe) of Ni and Fe to a P content satisfies the following Expression (2) of $3 < (Ni+Fe)/P < 15$ by atomic ratio, and a ratio Sn/(Ni+Fe) of a Sn content to the total content (Ni+Fe) of Ni and Fe satisfies the following Expression (3) of $0.3 < Sn/(Ni+Fe) < 5$ by atomic ratio.

Further, the copper alloy for an electric and electronic device according to the embodiment may further include 0.001 mass% to less than 0.10 mass% of Co in addition to Zn, Sn, Ni, Fe, and P described above.

Content ratios between the respective alloy elements are determined such that a ratio (Fe+Co)/Ni of a total content of Fe and Co to a Ni content satisfies the following Expression (1') of $0.002 \leq (Fe+Co)/Ni < 1.5$ by atomic ratio, a ratio (Ni+Fe+Co)/P of a total content (Ni+Fe+Co) of Ni, Fe, and Co to a P content satisfies the following Expression (2') of $3 < (Ni+Fe+Co)/P < 15$ by atomic ratio, and a ratio Sn/(Ni+Fe+Co) of a Sn content to the total content (Ni+Fe+Co) of Ni, Fe, and Co satisfies the following Expression (3') of $0.3 < Sn/(Ni+Fe+Co) < 5$ by atomic ratio.

Note that, the copper alloy satisfying Expressions (1), (2), and (3) further includes 0.001 mass% to less than 0.10 mass% of Co, the ratio (Fe+Co)/Ni of a total content of Fe and Co to a Ni content satisfies $0.002 \leq (Fe+Co)/Ni < 1.5$ by atomic ratio, the ratio (Ni+Fe+Co)/P of a total content (Ni+Fe+Co) of Ni, Fe, and Co to a P content satisfies $3 < (Ni+Fe+Co)/P < 15$ by atomic ratio, and the ratio Sn/(Ni+Fe+Co) of a Sn content to the total content (Ni+Fe+Co) of Ni, Fe, and Co satisfies $0.3 < Sn/(Ni+Fe+Co)$ by atomic ratio, accordingly Expressions (1'), (2'), and (3') are satisfied.

Here, the reasons for limiting the component composition as described above will be described.

Zinc (Zn): higher than 2 mass% and lower than 23 mass%

Zn is a basic alloy element in the copper alloy, which is a target of the embodiment and is an efficient element for improving strength and spring properties. In addition, Zn is cheaper than Cu and thus has an effect of reducing the material cost of the copper alloy. When the Zn content is 2 mass % or lower, the effect of reducing the material cost cannot be sufficiently obtained. On the other hand, when the Zn content is 23 mass% or more, corrosion resistance decreases, and cold workability also decreases.

Therefore, in the embodiment, the Zn content is in a range higher than 2 mass% and lower than 23 mass%. The Zn content is preferably in a range higher than 2 mass% and at 15 mass% or lower within the above-mentioned range, and more preferably in a range at 5 mass% or higher and at 15 mass% or lower.

Tin (Sn): 0.1 mass% to 0.9 mass%

Addition of Sn has an effect of improving strength of the copper alloy and is advantageous for improving the recycling efficiency of a Sn-plated Cu-Zn alloy. Further, as a result of a study by the present inventors, it was found that the presence of Sn together with Ni and Fe contributes to the improvement of stress relaxation resistance of the copper alloy. When the Sn content is less than 0.1 mass%, the above-described effects cannot be sufficiently obtained. On the other hand, when the Sn content is more than 0.9 mass%, hot workability and cold workability of the copper alloy decrease. Therefore, cracking may occur during hot rolling or cold rolling of the copper alloy, and conductivity may decrease.

Therefore, the Sn content is set in a range of 0.1 mass% to 0.9 mass%. The Sn content is more preferably in a range of 0.2 mass% to 0.8 mass%.

Nickel (Ni): at 0.05 mass% or more and lower than 1.0 mass%

By adding Ni together with Fe and P, a [Ni,Fe]-P-based precipitate can be precipitated from a matrix (mainly composed of $\alpha$ phase) of the copper alloy. In addition, by adding Ni together with Fe, Co, and P, a [Ni,Fe,Co]-P-based precipitate can be precipitated from a matrix (mainly composed of $\alpha$ phase) of the copper alloy. The [Ni,Fe]-P-based precipitate or the [Ni,Fe,Co]-P-based precipitate has an effect of pinning grain boundaries during recrystallization. As a result, the average grain size can be reduced, and strength, bendability, and stress corrosion cracking resistance of the copper alloy can be improved. Further, due to the presence of the precipitate, stress relaxation resistance of the copper alloy can be significantly improved. Further, by allowing Ni to be present together with Sn, Fe, Co, and P, stress relaxation resistance of the copper alloy can be improved due to solid solution strengthening. Here, when the addition amount of Ni is less than 0.05 mass%, stress relaxation resistance of the copper alloy cannot be sufficiently improved. On the other hand, when the addition amount of Ni is 1.0 mass% or more, the solid solution amount of Ni increases, and conductivity of the copper alloy decreases. In addition, due to an increase in the amount of an expensive Ni material used, the cost increases.

Therefore, the Ni content is in a range at 0.05 mass% or more and lower than 1.0 mass%. The Ni content is more preferably in a range of 0.2 mass% to less than 0.8 mass%.

Iron (Fe): 0.001 mass% to 0.08 mass%

By adding Fe together with Ni and P, a [Ni,Fe]-P-based precipitate can be precipitated from a matrix (mainly composed of $\alpha$ phase) of the copper alloy. In addition, by adding Fe together with Ni, Co, and P, a [Ni,Fe,Co]-P-based precipitate can be precipitated from a matrix (mainly composed of $\alpha$ phase) of the copper alloy. The [Ni,Fe]-P-based precipitate or the [Ni,Fe,Co]-P-based precipitate has an effect of pinning grain boundaries during recrystallization. As a result, the average grain size can be reduced, and strength, bendability, and stress corrosion cracking resistance of the copper alloy can be improved. Further, due to the presence of the precipitate, stress relaxation resistance of the copper alloy can be significantly improved. Here, when the addition amount of Fe is less than 0.001 mass%, the effect of pinning grain boundaries cannot be sufficiently obtained, and sufficient strength cannot be obtained. On the other hand, when the addition amount of Fe is 0.10 mass% or more, further improvement of strength cannot be recognized, the solid solution amount of Fe increases, and conductivity of the copper alloy decreases. In addition, cold rellability decreases.

Therefore, in the embodiment, the Fe content is in a range of 0.001 mass% to 0.08 mass%. The Fe content is more preferably in a range of 0.002 mass% to 0.08 mass%.

Cobalt (Co): 0.001 mass% to less than 0.10 mass%

Co is not an essential addition element. However, when a small amount of Co is added together with Ni, Fe, and P, a [Ni,Fe,Co]-P-based precipitate is produced, and stress relaxation resistance of the copper alloy can be further improved. Here, when the addition amount of Co is less than 0.001 mass%, the effect of further improving stress relaxation resistance obtained by the addition of Co cannot be obtained. On the other hand, when the addition amount of Co is 0.10 mass% or more, the solid solution amount of Co increases, and conductivity of the copper alloy decreases. In addition, due to an increase in the amount of an expensive Co material used, the cost increases.

Therefore, when Co is added, the Co content is in a range of 0.001 mass% to less than 0.10 mass%. The Co content is more preferably in a range of 0.002 mass% to 0.08 mass%. When Co is not actively added, less than 0.001 mass% of Co is contained as an impurity.

Phosphorous (P): 0.005 mass% to 0.10 mass%

P has high bonding properties with Fe, Ni, and Co. When an appropriate amount of P is added together with Fe and Ni, a [Ni,Fe]-P-based precipitate can be precipitated. In addition, when an appropriate amount of P is added together with Fe, Ni, and Co, a [Ni,Fe,Co]-P-based precipitate can be precipitated. Further, due to the presence of the precipitate, stress relaxation resistance of the copper alloy can be improved. When the P content is less than 0.005 mass%, it is difficult to precipitate a sufficient amount of the [Ni,Fe]-P-based precipitate or the [Ni,Fe,Co]-P-based precipitate, and stress relaxation resistance of the copper alloy cannot be sufficiently improved. On the other hand, when the P content exceeds 0.10 mass%, the solid solution amount of P increases, conductivity of the copper alloy decreases, rellability decreases, and cold rolling cracking is likely to occur.

Therefore, the P content is in a range of 0.005 mass% to 0.10 mass%. The P content is more preferably in a range of 0.01 mass% to 0.08 mass%.

P is an element which is likely to be unavoidably incorporated into molten raw materials of the copper alloy. Accordingly, in order to limit the P content to be as described above, it is desirable to appropriately select the molten raw materials.

Basically, the balance of the above-described elements is Cu and unavoidable impurities. Examples of the unavoidable impurities include Mg, Al, Mn, Si, (Co), Cr, Ag, Ca, Sr, Ba, Sc, Y, Hf, V, Nb, Ta, Mo, W, Re, Ru, Os, Se, Te, Rh, Ir, Pd, Pt, Au, Cd, Ga, In, Li, Ge, As, Sb, Ti, Tl, Pb, Bi, S, O, C, Be, N, H, Hg, B, Zr, rare earth element, and the like.

Further, in the copper alloy for an electric and electronic device according to the embodiment, it is important not only to adjust each content of the alloy elements to be in the above-described range, but also to limit the ratios between the respective content of the elements such that the above-described Expressions (1) to (3) or Expressions (1') to (3') are satisfied by atomic ratio. Therefore, the reason for limiting the ratios to satisfy Expressions (1) to (3) or Expressions (1') to (3') will be described below.

$$\text{Expression (1): } 0.002 \leq \text{Fe/Ni} < 1.5$$

As a result of a detailed experiment, the present inventors found that sufficient improvement of stress relaxation resistance can be realized not only by adjusting each content of Fe and Ni as described above but also by limiting the ratio Fe/Ni to be in a range of 0.002 to less than 1.5 by atomic ratio. Here, when the ratio Fe/Ni is 1.5 or more, stress relaxation resistance of the copper alloy decreases. When the ratio Fe/Ni is less than 0.002, strength of the copper alloy decreases, and the amount of an expensive Ni material used is relatively increased, which causes an increase in cost. Therefore, the ratio Fe/Ni is limited to be in the above-described range.

The Fe/Ni ratio is particularly preferably in the range of 0.002 to 0.5. Even more preferably, the Fe/Ni ratio is set in the range at 0.005 or higher to at 0.2 or lower.

$$\text{Expression (2): } 3 < (\text{Ni+Fe})/\text{P} < 15$$

When the ratio (Ni+Fe)/P is 3.0 or less, stress relaxation resistance of the copper alloy decreases along with an increase in the ratio of solid-solution element P. Concurrently, conductivity of the copper alloy decreases due to the solid-solution element P, rellability decreases, and thus cold rolling cracking is likely to occur. Further, bendability decreases. On the other hand, when the ratio (Ni+Fe)/P is 15 or more, conductivity of the copper alloy decreases along with an increase in the ratio of solid-solution elements Ni and Fe, and the amount of an expensive Ni material used is relatively increased, which causes an increase in cost. Therefore, the ratio (Ni+Fe)/P is limited to be in the above-described range. Note that, even in the above-described range, the (Ni+Fe)/P ratio is, preferably set to be in a range of more than 3 to 12.

$$\text{Expression (3): } 0.3 < \text{Sn/(Ni+Fe)} < 5$$

When the ratio Sn/(Ni+Fe) is 0.3 or less, the effect of improving stress relaxation resistance of the copper alloy cannot be sufficiently exhibited. On the other hand, when the ratio Sn/(Ni+Fe) is 5 or more, the (Ni+Fe) content is relatively decreased, the amount of a [Ni,Fe]-P-based precipitate decreases, and stress relaxation resistance of the copper alloy decreases. Therefore, the ratio Sn/(Ni+Fe) is limited to be in the above-described range. Note that, even in the above-described range, the Sn/(Ni+Fe) ratio is, particularly, preferably set to be in a range of more than 0.3 to 1.5.

## Expression (1'): $0.002 \leq (Fe+Co)/Ni < 1.5$

When Co is added, it can be considered that a portion of Fe is substituted with Co, and Expression (1') basically corresponds to Expression (1). Here, when the ratio (Fe+Co)/Ni is 1.5 or more, stress relaxation resistance of the copper alloy decreases, and the amount of an expensive Co material used increases, which causes an increase in cost. When the ratio (Fe+Co)/Ni is less than 0.002, strength of the copper alloy decreases, and the amount of an expensive Ni material used is relatively increased, which causes an increase in cost. Therefore, the ratio (Fe+Co)/Ni is limited to be in the above-described range. The (Fe+Co)/Ni ratio is particularly preferably in a range of 0.002 to 0.5. Even more preferably, The (Fe+Co)/Ni ratio is set in the range at 0.005 or higher to at 0.2 or lower.

## Expression (2'): $3 < (Ni+Fe+Co)/P < 15$

Expression (2'), which expresses the case where Co is added, corresponds to Expression (2). When the ratio (Ni+Fe+Co)/P is 3 or less, stress relaxation resistance decreases along with an increase in the ratio of solid-solution element P. Concurrently, conductivity of the copper alloy decreases due to the solid-solution element P, rellability decreases, and thus cold rolling cracking is likely to occur. Further, bendability decreases. On the other hand, when the ratio (Ni+Fe+Co)/P is 15 or more, conductivity of the copper alloy decreases along with an increase in the ratio of solid-solution elements Ni, Fe, and Co, and the amount of an expensive Co or Ni material used is relatively increased, which causes an increase in cost. Therefore, the ratio (Ni+Fe+Co)/P is limited to be in the above-described range. Note that, even in the above-described range, the (Ni+Fe+Co)/P ratio is preferably set to be in a range of more than 3 to 12.

## Expression (3'): $0.3 < Sn/(Ni+Fe+Co) < 5$

Expression (3'), which expresses the case where Co is added, corresponds to Expression (3). When the ratio Sn/(Ni+Fe+Co) is 0.3 or less, the effect of improving stress relaxation resistance cannot be sufficiently exhibited. On the other hand, when the ratio Sn/(Ni+Fe+Co) is 5 or more, the (Ni+Fe+Co) content is relatively decreased, the amount of a [Ni,Fe,Co]-P-based precipitate decreases, and stress relaxation resistance of the copper alloy decreases. Therefore, the ratio Sn/(Ni+Fe+Co) is limited to be in the above-described range. Note that, even in the above-described range, the Sn/(Ni+Fe+Co) ratio is preferably set to be in a range of more than 0.3 to 1.5.

As described above, in the copper alloy for an electric and electronic device in which not only each content of the respective alloy elements but also the ratios between the elements are adjusted so as to satisfy Expressions (1) to (3) or Expressions (1') to (3'), a [Ni,Fe]-P-based precipitate or a [Ni,Fe,Co]-P-based precipitate is dispersed and precipitated from a matrix (mainly composed of $\alpha$ phase). It is presumed that, due to the dispersion and precipitation of the precipitate, stress relaxation resistance of the copper alloy is improved.

In addition, in the copper alloy for an electric and electronic device of the present embodiment, the component composition is not only adjusted as described above but the crystal structure is regulated as described below.

First, $\alpha$ phase containing Cu, Zn and Sn within a measurement area of $1000\mu m^2$ or larger is measured by EBSD method with a measurement interval of $0.1\mu m$ a step. Then, data analysis is performed excluding measurement points with a CI value at 0.1 or less. The CI value is analyzed by a data analysis software OIM. Then, the grain boundary is identified between adjacent measurement points with a misorientation exceeding 15°. The special grain boundary length ratio, L$\sigma$/L, is 10% or more, where L$\sigma$/L is the ratio of L$\sigma$ to L, L$\sigma$ is the sum of each grain boundary length of: $\Sigma$3; $\Sigma$9; $\Sigma$27a; and $\Sigma$27b special grain boundaries, and L is the length of all crystal grain boundaries.

Moreover, the average crystal grain size of the $\alpha$ phase containing Cu, Zn and Sn including twinned crystals is set in the range of 0.5 $\mu m$ or more and 10 $\mu m$ or less.

Hereinafter, the reasons for regulating the crystal structure as described above will be described.

(Special grain boundary length ratio)

The special grain boundary is defined as the corresponding grain boundary: belonging to grain boundary with $3 \leq \Sigma \leq 29$ with $\Sigma$ value defined based on the CSL theory (Kronberg et al.: Trans. Met. Soc. AIME, 185, 501 (1949)) crystallographically; and satisfying $Dq \leq 15°/\Sigma^{1/2}$ (D. G. Brandon: Acta. Metallurgica. Vol. 14, p. 1479, (1966)). Dq is a lattice orientation defect at a specific corresponding site in the above-mentioned corresponding grain boundary.

The special grain boundary is the grain boundary with high crystallinity (grain boundaries with less disturbance of the atomic arrangement). Thus, when the special grain boundary length ratio L$\sigma$/L, where L$\sigma$ is the sum of each grain

boundary length of: $\Sigma 3$; $\Sigma 9$; $\Sigma 27a$; and $\Sigma 27b$ special grain boundaries, and L is the length of all crystal grain boundaries, is increased, bendability can be further improved while keeping the stress relaxation resistance of the copper alloy since formation of origins of the fracture during working is reduced. Preferably, the special grain boundary length ratio ($L\sigma/L$) is set to 15% or higher.

More preferably, the special grain boundary length ratio ($L\sigma/L$) is set to 20% or higher.

In terms of the CI value (confidence index) obtained in the analysis by the analysis software OIM of EBSD apparatus, the value is decreased in the case where the crystal pattern at the measurement point is not well-defined. Thus, when the CI value is 0.1 or less, it is hard to put high confidence on the obtained analysis result. Therefore, measurement points with the CI value at 0.1 or lower are excluded from the analysis in this embodiment.

(Average crystal grain size)

It is known that the crystal grain size affects stress relaxation resistance of the copper alloy to some extent. In general, the smaller the crystal grain size, the lower the relaxation resistance of the copper alloy. In the case of the copper alloy for an electric and electronic device, the excellent relaxation resistance of the copper alloy can be secured by appropriately controlling the composition of the components and the content ratios of the each of elements in the alloy; and the ratio of the special grain boundary with high crystallinity. Therefore, it is possible to reduce the crystal grain size to improve strength and bendability. Accordingly, it is preferable that the average crystal grain size is set to 10 $\mu$m or less in the step after the finish heat process for re-crystallization and precipitation during the production process. In order to further improve the balance between strength and bendability, it is preferable to set the average crystal grain size at 0.5 $\mu$m or larger and at 8 $\mu$m or smaller. More preferably, the average crystal grain size is set at 0.5 $\mu$m or larger and at 5 $\mu$m or smaller.

Further, in the copper alloy for an electric and electronic device according to the embodiment, the presence of the [Ni,Fe]-P-based precipitate or the [Ni,Fe,Co]-P-based precipitate is important. As a result of a study by the present inventors, it was found that the precipitate is a hexagonal crystal (space group:P-62 m (189)) having a $Fe_2P$-based or $Ni_2P$-based crystal structure, or a $Fe_2P$-based orthorhombic crystal (space group:P-nma (62)). It is preferable that the precipitate have a fine average grain size of 100 nm or less. Due to the presence of the precipitate having a fine grain size, superior stress relaxation resistance of the copper alloy can be secured, and strength and bendability can be improved through grain refinement. Here, when the average grain size of the precipitate exceeds 100 nm, contribution to the improvement of strength and stress relaxation resistance of the copper alloy decreases.

Next, a preferable example of a method of producing the above-described copper alloy for an electric and electronic device according to the embodiment will be described with reference to a flowchart shown FIG. 1.

[Melt Casting Step: S01]

First, molten copper alloy having the above-described component composition is prepared. As a copper material, 4NCu (for example, oxygen-free copper) having a purity of 99.99 % or higher is preferably used, and scrap may also be used as the material. In addition, for melting, an air atmosphere furnace may be used. However, in order to suppress oxidation of an addition element, an atmosphere furnace having an inert gas atmosphere or a reducing atmosphere may be used.

Next, the molten copper alloy with the components adjusted is cast into an ingot using an appropriate casting method such as a batch type casting method (for example, metal mold casting), a continuous casting method, or a semi-continuous casting method.

[Heating Step: S02]

Next, optionally, a homogenization heat treatment is performed to eliminate segregation of the ingot and homogenize the ingot structure. Alternatively, a solution heat treatment is performed to solid-solute a crystallized product or a precipitate. Heat treatment conditions are not particularly limited. Typically, heating may be performed at 600°C to 1000°C for 1 second to 24 hours. When the heat treatment temperature is lower than 600°C or when the heat treatment time is shorter than 5 minutes, a sufficient effect of homogenizing or solutionizing may not be obtained. On the other hand, when the heat treatment temperature exceeds 1000°C, a segregated portion may be partially melted. When the heat treatment time exceeds 24 hours, the cost increases. Cooling conditions after the heat treatment may be appropriately determined. Typically, water quenching may be performed. After the heat treatment, surface polishing may be performed.

[Hot Working: S03]

Next, hot working may be performed on the ingot to optimize rough processing and homogenize the structure. Hot working conditions are not particularly limited. Typically, it is preferable that the start temperature is 600°C to 1000°C, the end temperature is 300°C to 850°C, and the working ratio is about 10% to 99%. Until the start temperature of the hot working, ingot heating may be performed as the above-described heating step S02. Cooling conditions after the hot working may be appropriately determined. Typically, water quenching may be performed. After the hot working, surface polishing may be performed. A working method of the hot working is not particularly limited. In a case in which the final shape of the product is a plate or a strip, hot rolling may be applied. In addition, in a case in which the final shape of the product is a wire or a rod, extrusion or groove rolling may be applied. Further, in a case in which the final shape of the product is a bulk shape, forging or pressing may be applied.

[Intermediate Plastic Working: S04]

Next, intermediate plastic working is performed on the ingot which undergoes the homogenization treatment in the heating step S02 or the hot working material which undergoes the hot working S03 such as hot rolling. In the intermediate plastic working S04, temperature conditions are not particularly limited and are preferably in a range of -200°C to +200°C of a cold or warm working temperature. The working ratio of the intermediate plastic working is not particularly limited and is typically about 10% to 99%. An working method is not particularly limited. In a case in which the final shape of the product is a plate or a strip, rolling may be applied. In addition, in a case in which the final shape of the product is a wire or a rod, extrusion or groove rolling may be applied. Further, in a case in which the final shape of the product is a bulk shape, forging or pressing may be applied. S02 to S04 may be repeated to strictly perform solutionizing.

[Intermediate Heat Treatment Step: S05]

After the intermediate plastic working S04 at a cold or warm working temperature, an intermediate heat treatment is performed as a recrystallization treatment and a precipitation treatment. This intermediate heat treatment is performed not only to recrystallize the structure but also to disperse and precipitate a [Ni,Fe]-P-based precipitate or a [Ni,Fe,Co]-P-based precipitate. Conditions of the heating temperature and the heating time may be adopted to produce the precipitate. Typically, the conditions may be 200°C to 800°C and 1 second to 24 hours. However, the grain size affects stress relaxation resistance of the copper alloy to some extent. Therefore, it is preferable that the grain size of crystal grains recrystallized by the intermediate heat treatment is measured to appropriately select conditions of the heating temperature and the heating time. The intermediate heat treatment and the subsequent cooling affect the final average grain size. Therefore, it is preferable that the conditions are selected such that the average grain size of the $\alpha$ phase is in a range of 0.1 $\mu$m to 10 $\mu$m.

As a specific method of the intermediate heat treatment, a method using a batch type heating furnace or a continuous heating method using a continuous annealing line may be used. When the batch type heating furnace is used, it is preferable that heating is performed at a temperature of 300°C to 800°C for 5 minutes to 24 hours. In addition, when the continuous annealing line is used, it is preferable that the heating maximum temperature is set as 250°C to 800°C, and the temperature is not kept or only kept for about 1 second to 5 minutes in the above temperature range. In addition, it is preferable that the atmosphere of the intermediate heat treatment is a non-oxidizing atmosphere (nitrogen gas atmosphere, inert gas atmosphere, reducing atmosphere).

Cooling conditions after the intermediate heat treatment are not particularly limited. Typically, cooling may be performed at a cooling rate of 2000 °C/sec to 100 °C/h.

Optionally, the intermediate plastic working S04 and the intermediate heat treatment S05 may be repeated multiple times.

[Finish Plastic Working: S06]

After the intermediate heat treatment step S05, finish working is performed to obtain a copper alloy having a final dimension (thickness, width, and length) and a final shape. The working method for the finish plastic working is not particularly limited. In a case in which the shape of the final product is in a plate or a strip, rolling (cold rolling) may be applied. In addition, depending on the shape of the final product, forging, pressing, groove rolling, or the like may be applied. The working ratio may be appropriately selected according to the final thickness and the final shape and is preferably in a range of 1% to 99% and more preferably in a range of 1% to 70%. When the working ratio is less than 1%, an effect of improving yield strength cannot be sufficiently obtained. On the other hand, when the working ratio exceeds 70%, the recrystallized structure is lost, and a worked structure is obtained. As a result, bendability may decrease.

The working ratio is preferably 1% to 70% and more preferably 5% to 70%. After finish plastic working, the resultant may be used as a product without any change. However, typically, it is preferable that finish heat treatment is further performed.

[Finish Heat Treatment Step: S07]

After the finish plastic working, optionally, a finish heat treatment step S07 is performed to improve stress relaxation resistance of the copper alloy and perform low-temperature annealing curing or to remove residual strain. It is preferable that this finish heat treatment is performed in a temperature range of 50°C to 800°C for 0.1 seconds to 24 hours. When the finish heat treatment temperature is lower than 50°C or when the finish heat treatment time is shorter than 0.1 seconds, a sufficient straightening effect may not be obtained. On the other hand, when the finish heat treatment temperature exceeds 800°C, recrystallization may occur. When the finish heat treatment time exceeds 24 hours, the cost increases. When the finish plastic working S06 is not performed, the finish heat treatment step S07 can be omitted from the method of producing the copper alloy.

Through the above-described steps, the copper alloy for an electric and electronic device according to the embodiment can be obtained. In the copper alloy for an electric and electronic device, the 0.2% yield strength is 300 MPa or higher.

In addition, when rolling is used as a working method, a copper alloy sheet (strip) for an electric and electronic device having a thickness of about 0.05 mm to 1.0 mm can be obtained. This sheet may be used as the conductive component for an electric and electronic device without any change. However, typically, a single surface or both surfaces of the sheet are plated with Sn to have a thickness of 0.1 $\mu$m to 10 $\mu$m, and this Sn-plated copper alloy strip is used as a conductive component for an electric and electronic device such as a connector or other terminals. In this case, a Sn-plating method is not particularly limited. In addition, in some cases, a reflow treatment may be performed after electroplating.

In the copper alloy for an electric and electronic devices having the above-described configuration, a [Ni,Fe]-P-based precipitate or a [Ni,Fe,Co]-P-based precipitate which are precipitated from a matrix mainly composed of $\alpha$ phase is appropriately present. In addition to this, the special grain boundary length ratio, L$\sigma$/L, is 10% or more, where L$\sigma$/L is the ratio of L$\sigma$ to L, L$\sigma$ is the sum of each grain boundary length of: $\Sigma$3; $\Sigma$9; $\Sigma$27a; and $\Sigma$27b special grain boundaries in the $\alpha$ phase crystal grains, and L is the length of all crystal grain boundaries in the $\alpha$ phase crystal grains. As a result, stress relaxation resistance of the copper alloy is reliably and sufficiently superior; strength (yield strength) is high; and bendability is also superior.

Further, in the copper alloy for an electric and electronic device according to the present embodiment, the average grain size of the $\alpha$ phase is set in the range at 0.5 $\mu$m or larger and at 10 $\mu$m or smaller. As a result, stress relaxation resistance of the copper alloy is reliably and sufficiently superior; strength (yield strength) is high; and bendability is also superior.

Further, the copper alloy for an electric and electronic device according to the embodiment has mechanical properties including a 0.2% yield strength of 300 MPa or higher and thus is suitable for a conductive component in which high strength is particularly required, for example, a movable contact of an electromagnetic relay or a spring portion of a terminal.

The copper alloy sheet for an electric and electronic device according to the embodiment includes a rolled material formed of the above-described copper alloy for an electric and electronic device. Therefore, the copper alloy sheet for an electric and electronic device having the above-described configuration has superior stress relaxation resistance and can be suitably used for a connector, other terminals, a movable contact of an electromagnetic relay, or a lead frame.

In addition, when the surface of the copper alloy sheet is plated with Sn, a component such as a connector after use can be collected as scrap of a Sn-plated Cu-Zn alloy, and superior recycling efficiency can be secured.

The conductive component for an electric and electronic device and the terminal of the present invention is made of the above-described the copper alloy sheet for an electric and electronic device. The conductive component for an electric and electronic device and the terminal of the present invention are the conductive component for obtaining an electric connection with the opposite-side conductive member by bringing it into contact with the opposite-side conductive member. At least a part of the plate surface is subjected to bending in the conductive component for an electric and electronic device and the terminal of the present invention and they are configured to retain the connection with the opposite-side member by the spring properties of the bended portions. Thus, the copper alloy has superior relaxation resistance, and residual stress is not likely to be relaxed over time or in a high-temperature environment. Accordingly, the contact pressure with the opposite-side conductive member can be maintained.

Hereinabove, the embodiment of the present invention has been described. However, the present invention is not limited to the embodiment, and appropriate modifications can be made within a range not departing from the technical scope of the present invention.

For example, the example of the production method has been described, but the present invention is not limited thereto. The production method is not particularly limited as long as a copper alloy for an electric and electronic device as a final product has a composition in the range according to the present invention, and the special grain boudary length ratio (Lσ/L) of the α phase containing Cu, Zn and Sn is set in the range defined in the present invention.

EXAMPLES

Hereinafter, the results of an experiment which were performed in order to verify the effects of the present invention will be shown as Examples of the present invention together with Comparative Examples. The following Examples are to describe the effects of the present invention, and configurations, processes, and conditions described in Examples do not limit the technical scope of the present invention.

A raw material made up of a Cu-40% Zn master alloy and oxygen-free copper (ASTM B152 C10100) with a purity of 99.99 mass% or more was prepared. Then, these materials were set in a crucible made of high purity graphite and melted using an electric furnace in a $N_2$ gas atmosphere. A various elements were added into the molten copper alloy, thereby molten alloys having the component compositions shown in Tables 1, 2, and 3 were prepared and were poured into carbon molds to prepare ingots. The size of the ingots was about 25 mm (thickness)×about 50 mm (width)×about 200 mm (length).

Next, each ingot was subjected to a homogenization treatment (heating step S02), in which the ingots were held in a high purity Ar gas atmosphere at 800°C for a predetermined amount of time and then were water-quenched.

Next, hot rolling was performed as the hot working S03. Each of the ingots was reheated such that the hot rolling start temperature was 800°C, was hot-rolled at a rolling reduction of 50% such that a width direction of the ingot was a rolling direction, and was water-quenched such that the rolling end temperature was 300°C to 700°C. Next, the ingot was cut, and surface polishing was performed. As a result, a hot-rolled material having a size of about 11 mm (thickness)×about 160 mm (width)×about 100 mm (length).

Next, the intermediate plastic working and the intermediate heat treatment step were performed once or were repeatedly performed twice.

Specifically, when the intermediate plastic working and the intermediate heat treatment were performed once, cold rolling (intermediate plastic working) was performed at a rolling reduction of 90% or more. Next, as the intermediate heat treatment for recrystallization and precipitation treatment, a heat treatment was performed at 200°C to 800°C for a predetermined amount of time, and then water quenching was performed. After that, the rolled material was cut, and surface polishing was performed to remove an oxide film.

On the other hand, when the intermediate plastic working and the intermediate heat treatment were repeated twice, primary cold rolling (primary intermediate plastic working) was performed at a rolling reduction of about 50% to 90%. Next, as a primary intermediate heat treatment, a heat treatment was performed at 200°C to 800°C for a predetermined amount of time, and water quenching was performed. After that, secondary cold rolling (secondary intermediate plastic working) was performed at a rolling reduction of about 50% to 90%, a secondary intermediate heat treatment was performed at 200°C to 800°C for a predetermined amount of time, and then water quenching was performed. Next, the rolled material was cut, and surface polishing was performed to remove an oxide film.

The average grain sizes after the first and second intermediate heat treatments were examined as explained below.

In the case where the average grain size exceeded 10 μm, the image of the observed surface perpendicular to the rolled surface in the normal line direction (ND: Normal Direction), was taken by an optical microscope in such a way that the rolling direction is in the horizontal direction in the image after mirror-grinding and etching. By using the photographed image, the viewing field in 1000-fold magnification (about 300 $\mu m^2 \times 200 \mu m^2$) was observed. Then, based on the standardized cutting method defined as JIS H 0501:1986 (which corresponds to ISO 2624-1973), the crystal grain size was calculated by: drawing a set of five line segments having the predetermined length vertically and horizontally in the image; counting the number of crystal grains completely sectioned by each of the lines; and obtaining the average value of the cut lengths as the average crystal grain size.

In the case where the average grain size is 10 μm or less, the average crystal grain size was calculated by observing the surface perpendicular to the width direction of the rolling direction (TD (Traverse Direction) surface) by using SEM-EBSD (Electron Backscatter Diffraction Patterns) measurement apparatus. Specifically, finishing grinding was performed using a colloidal silica solution after performing machine grinding using a piece of waterproof abrasive paper and diamond abrasive grains. Then, a crystal grain map was produced by using a scanning electron microscope: by irradiating the electron beam to each of measurement points (pixels) within the measurement area on the sample surface; and by regarding the location between adjacent measurement points with a misorientation exceeding 15° to be the crystal grain boundary based on the orientation analysis of the electron backscattering diffraction pattern. Then, by using the obtained grain boundary map, the average crystal grain size was obtained by: drawing a set of five line segments having the predetermined length vertically and horizontally in the grain boundary map; counting the number of crystal grains completely sectioned by each of the lines; and obtaining the average value of the cut lengths as the average crystal grain size.

The average grain sizes examined as explained above in the steps after the first and second intermediate heat treatments are shown in Tables 5 and 6.

After that, finish rolling was performed at a rolling reduction as shown in Tables 3 and 4.

Finally, a finish heat treatment was performed at 200°C to 400°C, water quenching was performed, and cutting and surface-polishing were performed. As a result, a strip for characteristic evaluation having a size of 0.25 mm (thickness) × about 160 mm (width) was prepared.

Regarding the strip for characteristic evaluation, conductivity, mechanical properties (yield strength), and relaxation resistance of the copper alloy were analyzed. In addition, observation of the structure of the copper alloy was performed. Test methods and measurement methods for each evaluation item are as follows, and the results thereof are shown in Tables 5, and 6.

[Mechanical Properties]

A No. 13B specified in JIS Z 2201: 1998 (which corresponds to the current JIS Z 2241: 2011 that is based on ISO 6892-1: 2009) was collected from the strip for characteristic evaluation, and the 0.2% yield strength $\sigma_{0.2}$ using an offset method according to JIS Z 2241: 2011. The offset method is the method for measuring the stress in the condition where the plastic elongation relative to the length indicated by the extensometer (length before pulling) equals to the predetermined percentage in the tensile test. In the present example, the stress when the above-defined percentage turned to 0.2% was measured. The specimen was collected such that a tensile direction of a tensile test was perpendicular to the rolling direction of the strip for characteristic evaluation.

[Conductivity]

A specimen having a size of 10 mm (width)×60 mm (length) was collected from the strip for characteristic evaluation, and the electrical resistance thereof was obtained using a four-terminal method. In addition, using a micrometer, the size of the specimen was measured, and the volume of the specimen was calculated. The conductivity was calculated from the measured electrical resistance and the volume. The specimen was collected such that a longitudinal direction thereof was parallel to the rolling direction of the strip for characteristic evaluation.

[Stress Relaxation Resistance]

In a stress relaxation resistance test of the copper alloy, using a method specified in a cantilever screw method of JCBA (Japan Copper and Brass Association)-T309:2004, in which one end of the specimen was held as the fixed end and another free end was allowed to have displacement, a stress was applied to the specimen, the specimen was held at the temperatures explained below for predetermined temperatures, and the residual stress ratio thereof was measured. In terms of the specimen, which included Zn exceeding 2% and less than 15% (specimens with descriptions in the column "2-15Zn Evaluation" in Tables 5 and 6), the temperature was set to 150°C. In terms of the specimen, which included Zn at 15% or higher and less than 23% (specimens with descriptions in the column "15-23Zn Evaluation" in Tables 5 and 6), the temperature was set to 120°C.

In the test method, a specimen (width: 10 mm) was collected from each of the strips for characteristic evaluation in a direction perpendicular to the rolling direction. An initial deflection displacement was set as 2 mm, and the span length was adjusted such that a surface maximum stress of the specimen was 80% of the yield strength. The surface maximum stress was determined from the following expression.

$$\text{Surface Maximum Stress (MPa)}=1.5\ Et\delta_0/L_s{}^2$$

(wherein E: deflection coefficient (MPa), t: thickness of sample (t=0.25 mm), $\delta_0$: initial deflection displacement (2 mm), $L_s$: span length (mm))

In the evaluation of stress relaxation resistance of the copper alloy, in terms of the specimen, which included Zn exceeding 2% and less than 15% (specimens with descriptions in the column "2-15Zn Evaluation" in Tables 5 and 6), the residual stress rate was measured from the bent portion after the test piece was held for 1000 hours at a temperature of 150°C to evaluate stress relaxation resistance of the copper alloy. The residual stress ratio was calculated using the following expression.

In terms of the specimen, which included Zn at 15% or higher and less than 23% (specimens with descriptions in the column "15-23Zn Evaluation" in Tables 5 and 6), the residual stress rate was measured from the bent portion after the test piece was held for 1000 hours at a temperature of 120°C to evaluate stress relaxation resistance of the copper alloy. The residual stress ratio was calculated using the following expression.

$$\text{Residual Stress Ratio } (\%) = (1-\delta_t/\delta_0) \times 100$$

(wherein $\delta_t$: permanent deflection displacement (mm) after holding at 120°C or 150°C for 1000 h - permanent deflection displacement (mm) after holding at room temperature for 24 h, $\delta_0$: initial deflection displacement (mm))

A case where the residual stress ratio was 70% or more was evaluated to be favorable "A", and a case where the residual stress ratio was less than 70% was evaluated to be poor "B".

[Grain Size Observation]

A surface perpendicular to the width direction of rolling, that is, a TD (transverse direction) surface was used as an observation surface. Using an EBSD measurement device and an OIM analysis software, grain boundaries and an orientation difference distribution were measured.

Mechanical polishing was performed using waterproof abrasive paper and diamond abrasive grains, and finish polishing was performed using a colloidal silica solution. Using an EBSD measurement device (QUANTA FEG 450 manufactured by FEI Company, OIM DATA COLLECTION manufactured by EDAX/TSL (at present, AMETEK Inc.)) and an analysis software (OIM DATA ANALYSIS Ver. 5.3 manufactured by EDAX/TSL (at present, AMETEK Inc.)), an orientation differences between crystal grains was analyzed under conditions of an acceleration voltage of electron beams of 20 kV, a measurement interval of 0.1 $\mu$m step, and a measurement area of 1000 $\mu m^2$ or more. The CI values of the measurement points were calculated from the analysis software OIM, and CI values of 0.1 or less were excluded by the analysis of the grain size. By defining crystal grain boundary as the location between adjacent measurement points with a misorientation exceeding 15° as the crystal grain boundary, a grain boundary map was created. Five line segments having predetermined horizontal and vertical lengths were drawn in the image according to a cutting method of JIS H 0501, the number of crystal grains which were completely cut was counted, and the average value of the cut lengths thereof was calculated as the average grain size.

[Observation of precipitates]

Observation of precipitates was performed on the strips for characteristic evaluation by using the transmission electron microscope (TEM: Model H-800, HF-2000, HF-2200 manufactured by Hitachi, Ltd.; and Model JEM-2010F manufacture by JEOL Ltd.) and the EDX analysis apparatus as explained below.

By using TEM, observation of precipitates having grain sizes of 10-100 nm was performed at 150,000-fold magnification (observing view area was about $4 \times 10^5 nm^2$) and 750,000-fold magnification (observing view area was about $2 \times 10^4 nm^2$). In addition, the crystal structures of the precipitates were identified by electron beam diffraction pattern of the precipitates. In addition, compositions of the precipitates were analyzed by using EDX (Energy dispersive X-ray spectrometer).

[Bendability]

Bending was performed according to a test method of JCBA (Japan Copper and Brass Association) T307-2007-4. W bending was performed such that a bending axis was parallel to a rolling direction. Multiple specimens having a size of 10 mm (width)×30 mm (length)×0.25 mm (thickness) were collected from the strip for characteristic evaluation. Next, a W-bending test was performed using a W-shaped jig having a bending angle of 90° and a bending radius of 0.25 mm. A cracking test was performed using three samples. A case where no cracks were observed in four visual fields of each sample was evaluated as "A", and a case where cracks were observed in one or more visual fields of each sample was evaluated as "B". The evaluation results are shown in Tables 5 and 6.

[Special grain boundary grain length ratio]

A surface perpendicular to the width direction of rolling, that is, a TD (transverse direction) surface was used as an observation surface. Using an EBSD measurement device and an OIM analysis software, grain boundaries and an orientation difference distribution were measured.

Mechanical polishing was performed using waterproof abrasive paper and diamond abrasive grains, and finish polishing was performed using a colloidal silica solution. Using an EBSD measurement device (QUANTA FEG 450 manufactured by FEI Company, OIM DATA COLLECTION manufactured by EDAX/TSL (at present, AMETEK Inc.)) and an analysis software (OIM DATA ANALYSIS Ver. 5.3 manufactured by EDAX/TSL (at present, AMETEK Inc.)), an orientation differences between crystal grains was analyzed under conditions of an acceleration voltage of electron beams of 20 kV, a measurement interval of 0.1 $\mu$m step, and a measurement area of 1000 $\mu$m$^2$ or more. After excluding the measurement points with the CI value of 0.1 or lower, the misorientation analysis was performed on each of crystal grains. The location between adjacent measurement points with a misorientation exceeding 15° was defined as the crystal grain.

In addition, the length of all crystal grain boundaries in the measurement area was measured; and the locations of grain boundaries in which the grain boundary of adjacent crystal grains constituted the special grain boundary were determined. Then, the ratio L$\sigma$/L, where L$\sigma$ was the sum of each grain boundary length of: $\Sigma$3; $\Sigma$9; $\Sigma$27a; and $\Sigma$27b special grain boundaries and L was the length of all crystal grain boundaries, was obtained to have the special grain boundary length ratio (L$\sigma$/L).

Results of the above-described structure observation and each of evaluations are shown in Tables 5 and 6.

[Table 1]

| No. | Alloy component composition | | | | | | | Atomic ratios of alloy element | | |
|---|---|---|---|---|---|---|---|---|---|---|
| | Zn | Sn | Ni | Fe | P | Co | Cu | (Fe+Co) /Ni atomic ratio | (Ni+Fe+Co) /P atomic ratio | Sn/ (Ni+Fe+Co) atomic ratio |
| | | | | | | | | [Example of the present invention] | | |
| 1 | 22.7 | 0.55 | 0.56 | 0.016 | 0.044 | - | balance | 0.030 | 6.9 | 0.47 |
| 2 | 22.7 | 0.55 | 0.56 | 0.016 | 0.044 | - | balance | 0.030 | 6.9 | 0.47 |
| 3 | 22.7 | 0.55 | 0.56 | 0.016 | 0.044 | - | balance | 0.030 | 6.9 | 0.47 |
| 4 | 18.9 | 0.24 | 0.29 | 0.022 | 0.054 | - | balance | 0.080 | 3.1 | 0.38 |
| 5 | 19.5 | 0.88 | 0.45 | 0.010 | 0.044 | - | balance | 0.023 | 5.5 | 0.94 |
| 6 | 20.4 | 0.59 | 0.85 | 0.017 | 0.051 | - | balance | 0.021 | 9.0 | 0.34 |
| 7 | 19.3 | 0.46 | 0.24 | 0.021 | 0.041 | - | balance | 0.092 | 3.4 | 0.87 |
| 8 | 20.1 | 0.61 | 0.57 | 0.005 | 0.056 | - | balance | 0.009 | 5.4 | 0.52 |
| 9 | 22.1 | 0.57 | 0.57 | 0.002 | 0.053 | - | balance | 0.004 | 5.7 | 0.49 |
| 10 | 20.4 | 0.64 | 0.50 | 0.001 | 0.058 | - | balance | 0.002 | 4.6 | 0.63 |
| 11 | 21.1 | 0.49 | 0.49 | 0.075 | 0.060 | - | balance | 0.161 | 5.0 | 0.43 |
| 12 | 20.4 | 0.66 | 0.51 | 0.010 | 0.029 | - | balance | 0.021 | 9.5 | 0.63 |
| 13 | 19.8 | 0.48 | 0.53 | 0.001 | 0.054 | 0.001 | balance | 0.004 | 5.2 | 0.45 |
| 14 | 18.3 | 0.57 | 0.61 | 0.002 | 0.062 | 0.002 | balance | 0.007 | 5.2 | 0.46 |
| 15 | 17.2 | 0.60 | 0.65 | 0.040 | 0.080 | - | balance | 0.065 | 4.6 | 0.43 |
| 16 | 19.6 | 0.62 | 0.65 | 0.011 | 0.057 | 0.024 | balance | 0.055 | 6.3 | 0.45 |
| 17 | 15.2 | 0.60 | 0.54 | 0.010 | 0.053 | - | balance | 0.019 | 5.5 | 0.54 |
| 18 | 10.2 | 0.62 | 0.57 | 0.012 | 0.049 | - | balance | 0.022 | 6.3 | 0.53 |
| 19 | 10.2 | 0.62 | 0.57 | 0.012 | 0.049 | - | balance | 0.022 | 6.3 | 0.53 |
| 20 | 9.6 | 0.23 | 0.35 | 0.012 | 0.051 | - | balance | 0.036 | 3.8 | 0.31 |
| 21 | 9.3 | 0.89 | 0.52 | 0.023 | 0.045 | - | balance | 0.046 | 6.4 | 0.81 |
| 22 | 10.0 | 0.73 | 0.29 | 0.011 | 0.044 | - | balance | 0.040 | 3.6 | 1.20 |
| 23 | 9.2 | 0.59 | 0.85 | 0.025 | 0.055 | - | balance | 0.031 | 8.4 | 0.33 |
| 24 | 9.6 | 0.62 | 0.56 | 0.006 | 0. | - | balance | 0.011 | 6.1 | 0.54 |

(continued)

| | [Example of the present invention] | | | | | | | | | |
|---|---|---|---|---|---|---|---|---|---|---|
| | Alloy component composition | | | | | | | Atomic ratios of alloy element | | |
| No. | Zn | Sn | Ni | Fe | P | Co | Cu | (Fe+Co) /Ni atomic ratio | (Ni+Fe+Co) /P atomic ratio | Sn/ (Ni+Fe+Co) atomic ratio |
| 25 | 10.6 | 0.54 | 0.48 | 0.002 | 0.052 | - | balance | 0.004 | 4.9 | 0.55 |
| 26 | 10.2 | 0.56 | 0.49 | 0.001 | 0.049 | - | balance | 0.002 | 5.3 | 0.56 |
| 27 | 11.4 | 0.75 | 0.65 | 0.047 | 0.088 | - | balance | 0.076 | 4.2 | 0.53 |
| 28 | 9.0 | 0.52 | 0.57 | 0.001 | 0.050 | 0.001 | balance | 0.004 | 6.0 | 0.45 |
| 29 | 8.9 | 0.57 | 0.54 | 0.002 | 0.046 | 0.002 | balance | 0.008 | 6.2 | 0.52 |
| 30 | 8.2 | 0.49 | 0.56 | 0.021 | 0.054 | 0.014 | balance | 0.064 | 5.8 | 0.41 |
| 31 | 4.5 | 0.64 | 0.53 | 0.019 | 0.053 | - | balance | 0.038 | 5.5 | 0.58 |
| 32 | 4.5 | 0.64 | 0.53 | 0.019 | 0.053 | - | balance | 0.038 | 5.5 | 0.58 |
| 33 | 4.9 | 0.31 | 0.47 | 0.017 | 0.045 | - | balance | 0.038 | 5.7 | 0.31 |
| 34 | 5.9 | 0.70 | 0.46 | 0.036 | 0.056 | - | balance | 0.082 | 4.7 | 0.70 |
| 35 | 6.2 | 0.58 | 0.31 | 0.056 | 0.058 | - | balance | 0.190 | 3.4 | 0.78 |
| 36 | 5.4 | 0.60 | 0.87 | 0.015 | 0.045 | - | balance | 0.018 | 10.4 | 0.33 |
| 37 | 4.9 | 0.51 | 0.60 | 0.007 | 0.054 | - | balance | 0.012 | 5.9 | 0.42 |
| 38 | 5.2 | 0.69 | 0.65 | 0.083 | 0.063 | - | balance | 0.134 | 6.2 | 0.46 |
| 39 | 5.5 | 0.60 | 0.57 | 0.010 | 0.027 | - | balance | 0.018 | 11.3 | 0.51 |
| 40 | 5.3 | 0.71 | 0.62 | 0.022 | 0.078 | - | balance | 0.037 | 4.4 | 0.55 |
| 41 | 4.9 | 0.62 | 0.58 | 0.009 | 0.051 | 0.022 | balance | 0.054 | 6.3 | 0.50 |
| 42 | 3.6 | 0.59 | 0.49 | 0.032 | 0.055 | - | balance | 0.069 | 5.0 | 0.56 |

[Table 2]

| | Alloy component composition | | | | | | | Atomic ratios of alloy element | | |
|---|---|---|---|---|---|---|---|---|---|---|
| No. | Zn | Sn | Ni | Fe | P | Co | Cu | (Fe+Co)/Ni atomic ratio | (Ni+Fe+Co) /P atomic ratio | Sn/ (Ni+Fe+Co) atomic ratio |
| 50 | 28.9 | - | - | - | - | - | balance | - | - | - |
| 51 | 21.4 | 0.61 | 0.59 | 0.021 | 0.051 | - | balance | 0.037 | 6.3 | 0.49 |
| 52 | 20.1 | 1.1 | - | - | - | - | balance | - | - | - |
| 53 | 19.4 | - | 1.2 | - | - | - | balance | 0.000 | - | 0.00 |
| 54 | 14.8 | - | - | - | 0.004 | - | balance | - | 0.0 | - |
| 55 | 14.1 | 0.41 | - | 0.21 | 0.110 | - | balance | - | 1.1 | 0.92 |
| 56 | 14.7 | 0.01 | 0.04 | - | 0.001 | - | balance | 0.000 | 21.1 | 0.12 |
| 57 | 5.1 | - | - | - | | - | balance | - | - | - |

[Table 3]

| | | Steps | | | |
|---|---|---|---|---|---|
| No. | Homogenization temperature (°C) | Hot rolling start temperature (°C) | Average grain size after intermediate treatment (μm) | Finish rolling reduction (%) | Finish heat treatment temperature (°C) |
| | | | [Examples of the present invention] | | |
| 1 | 800 | 800 | 2.9 | 35 | 400 |
| 2 | 800 | 800 | 2.7 | 24 | 350 |
| 3 | 800 | 800 | 2.0 | 9 | 300 |
| 4 | 800 | 800 | 3.2 | 26 | 350 |
| 5 | 800 | 800 | 2.4 | 31 | 350 |
| 6 | 800 | 800 | 2.5 | 25 | 300 |
| 7 | 800 | 800 | 2.7 | 21 | 325 |
| 8 | 800 | 800 | 2.6 | 29 | 350 |
| 9 | 800 | 800 | 2.5 | 28 | 325 |
| 10 | 800 | 800 | 2.5 | 25 | 300 |
| 11 | 800 | 800 | 2.4 | 25 | 325 |
| 12 | 800 | 800 | 2.4 | 31 | 300 |
| 13 | 800 | 800 | 2.6 | 27 | 350 |
| 14 | 800 | 800 | 2.5 | 26 | 325 |
| 15 | 800 | 800 | 2.0 | 29 | 350 |
| 16 | 800 | 800 | 2.1 | 29 | 300 |
| 17 | 800 | 800 | 2.3 | 43 | 350 |
| 18 | 800 | 800 | 2.6 | 34 | 350 |
| 19 | 800 | 800 | 2.6 | 56 | 350 |
| 20 | 800 | 800 | 2.8 | 46 | 325 |
| 21 | 800 | 800 | 2.5 | 48 | 300 |
| 22 | 800 | 800 | 3.9 | 55 | 350 |
| 23 | 800 | 800 | 2.9 | 54 | 375 |
| 24 | 800 | 800 | 2.6 | 55 | 325 |
| 25 | 800 | 800 | 2.8 | 51 | 300 |
| 26 | 800 | 800 | 3.2 | 56 | 300 |
| 27 | 800 | 800 | 3.1 | 54 | 350 |
| 28 | 800 | 800 | 2.7 | 53 | 300 |
| 29 | 800 | 800 | 2.6 | 54 | 325 |
| 30 | 800 | 800 | 3.8 | 49 | 350 |
| 31 | 800 | 800 | 2.9 | 53 | 350 |
| 32 | 800 | 800 | 3.1 | 69 | 300 |
| 33 | 800 | 800 | 3.5 | 61 | 350 |
| 34 | 800 | 800 | 3.2 | 54 | 375 |

(continued)

| No. | Homogenization temperature (°C) | Hot rolling start temperature (°C) | Average grain size after intermediate treatment ($\mu$m) | Finish rolling reduction (%) | Finish heat treatment temperature (°C) |
|---|---|---|---|---|---|
| | | [Examples of the present invention] | | | |
| | | Steps | | | |
| 35 | 800 | 800 | 3.4 | 58 | 300 |
| 36 | 800 | 800 | 3.3 | 63 | 350 |
| 37 | 800 | 800 | 4.9 | 52 | 325 |
| 38 | 800 | 800 | 3.3 | 55 | 300 |
| 39 | 800 | 800 | 4.0 | 58 | 325 |
| 40 | 800 | 800 | 3.5 | 53 | 350 |
| 41 | 800 | 800 | 3.3 | 60 | 325 |
| 42 | 800 | 800 | 4.0 | 69 | 300 |

[Table 4]

| No. | Homogenization temperature (°C) | H ot rolling start temperature (°C) | Average grain size after intermediate heat treatment ($\mu$m) | Finish rolling reduction (%) | Finish heat treatment temperature (°C) |
|---|---|---|---|---|---|
| | | [Comparative Example] | | | |
| | | Steps | | | |
| 50 | 800 | 800 | 2.6 | 29 | 300 |
| 51 | 800 | 800 | 2.0 | 92 | 300 |
| 52 | 800 | 800 | 6.7 | 19 | 300 |
| 53 | 800 | 800 | 6.1 | 26 | 250 |
| 54 | 800 | 800 | 116 | 42 | 300 |
| 55 | 800 | 800 | 1.8 | 54 | 250 |
| 56 | 800 | 800 | 4.5 | 34 | 300 |
| 57 | 800 | 800 | 80 | 22 | 200 |

[Table 5]

| No. | Special grain boundary length ratio LolL | Average grain size ($\mu$m) | Conductivity (%IACS) | Yield strength (MPa) | Bendability | 2-15Zn Evaluation | 15-23Zn Evaluation |
|---|---|---|---|---|---|---|---|
| | | [Example of the present invention] | | | | | |
| | Structure | | Evaluation | | | | |
| | | | | | | Stress relaxation resistance | |
| 1 | 29% | 2.4 | 25 | 563 | A | - | A |
| 2 | 36% | 2.1 | 25 | 516 | A | - | A |
| 3 | 57% | 1.9 | 24 | 455 | A | - | A |
| 4 | 38% | 2.6 | 26 | 583 | A | - | A |
| 5 | 26% | 1.8 | 23 | 577 | A | - | A |

(continued)

| No. | Structure | | Evaluation | | | | |
| | Special grain boundary length ratio LoIL | Average grain size (μm) | Conductivity (%IACS) | Yield strength (MPa) | Bendability | Stress relaxation resistance | |
| | | | | | | 2-15Zn Evaluation | 15-23Zn Evaluation |
|---|---|---|---|---|---|---|---|
| 6 | 32% | 2.0 | 22 | 634 | A | - | A |
| 7 | 40% | 2.1 | 26 | 524 | A | - | A |
| 8 | 39% | 2.0 | 24 | 546 | A | - | A |
| 9 | 34% | 2.1 | 24 | 526 | A | - | A |
| 10 | 33% | 2.0 | 25 | 525 | A | - | A |
| 11 | 34% | 1.9 | 22 | 604 | A | - | A |
| 12 | 29% | 1.9 | 24 | 559 | A | - | A |
| 13 | 36% | 2.1 | 26 | 528 | A | - | A |
| 14 | 41% | 2.0 | 25 | 560 | A | - | A |
| 15 | 35% | 1.5 | 23 | 604 | A | - | A |
| 16 | 31% | 1.6 | 23 | 601 | A | - | A |
| 17 | 29% | 1.5 | 26 | 581 | A | - | A |
| 18 | 32% | 1.6 | 29 | 567 | A | A | - |
| 19 | 20% | 1.4 | 28 | 603 | A | A | - |
| 20 | 25% | 1.7 | 33 | 541 | A | A | - |
| 21 | 24% | 1.5 | 28 | 554 | A | A | - |
| 22 | 25% | 2.3 | 30 | 519 | A | A | - |
| 23 | 22% | 1.6 | 29 | 543 | A | A | - |
| 24 | 19% | 1.4 | 30 | 596 | A | A | - |
| 25 | 23% | 1.6 | 30 | 546 | A | A | - |
| 26 | 27% | 1.7 | 31 | 530 | A | A | - |
| 27 | 28% | 1.7 | 29 | 598 | A | A | - |
| 28 | 33% | 1.5 | 31 | 512 | A | A | - |
| 29 | 30% | 1.4 | 32 | 533 | A | A | - |
| 30 | 28% | 2.3 | 31 | 514 | A | A | - |
| 31 | 29% | 1.5 | 36 | 513 | A | A | - |
| 32 | 11% | 0.8 | 36 | 567 | A | A | - |
| 33 | 23% | 2.1 | 38 | 502 | A | A | - |
| 34 | 25% | 1.9 | 32 | 505 | A | A | - |
| 35 | 24% | 1.9 | 32 | 512 | A | A | - |
| 36 | 29% | 1.7 | 32 | 511 | A | A | - |
| 37 | 27% | 4.2 | 37 | 445 | A | A | - |
| 38 | 26% | 1.8 | 33 | 500 | A | A | - |
| 39 | 20% | 2.1 | 35 | 461 | A | A | - |

(continued)

| | [Example of the present invention] | | | | | | |
|---|---|---|---|---|---|---|---|
| | Structure | | Evaluation | | | | |
| No. | Special grain boundary length ratio LσlL | Average grain size (μm) | Conductivity (%IACS) | Yield strength (MPa) | Bendability | Stress relaxation resistance | |
| | | | | | | 2-15Zn Evaluation | 15-23Zn Evaluation |
| 40 | 21% | 1.8 | 32 | 512 | A | A | - |
| 41 | 19% | 1.6 | 35 | 511 | A | A | - |
| 42 | 15% | 1.8 | 38 | 495 | A | A | - |

[Table 6]

| | [Comparative Example] | | | | | | |
|---|---|---|---|---|---|---|---|
| | Structure | | Evaluation | | | | |
| No. | Special grain boundary length ratio Lσ/L | Average grain size (μm) | Conductivity (%IACS) | Yield strength (MPa) | Bendability | Stress relaxation resistance | |
| | | | | | | 2-15Zn Evaluation | 15-23Zn Evaluation |
| 50 | 36% | 2.6 | 28 | 531 | A | - | B |
| 51 | 8% | 0.7 | 24 | 887 | B | - | - |
| 52 | 53% | 5.8 | 26 | 517 | A | - | B |
| 53 | 38% | 5.4 | 27 | 522 | A | - | B |
| 54 | 46% | 100 | 33 | 402 | A | B | - |
| 55 | 17% | 1.0 | 23 | 603 | A | B | - |
| 56 | 41% | 3.3 | 36 | 449 | A | B | - |
| 57 | 29% | 69 | 59 | 287 | A | B | - |

Evaluation results of each of the above-described samples are explained below.

The samples No. 1 to No. 16 are Examples of the present invention based on the Cu-20Zn alloy including Zn around 20%. The sample No. 17 is an Example of the present invention based in the Cu-15Zn alloy including Zn around 15%. The samples No. 18 to No. 30 are Examples of the present invention based on the Cu-10Zn alloy including Zn around 10%. The samples No. 31 to No. 41 are Examples of the present invention based on the Cu-5Zn alloy including Zn around 5%. The sample No. 42 is an Example of the present invention based on the Cu-3Zn alloy including Zn around 3%.

The sample No. 50 is a Comparative Example, Zn content of which exceeds the upper limit of the scope of the present invention. The samples No.51 to No. 53 are Comparative Examples based on the Cu-20Zn alloy including Zn around 20%. The samples No. 54 to No. 56 are Comparative Examples based on the Cu-15Zn alloy including Zn around 15%. The sample No. 57 is a Comparative Example based on the Cu-5Zn alloy including Zn around 5%.

As shown in Table 5, the stress relaxation resistance of the copper alloy was excellent in any one of Examples No. 1 to 42 of the present invention, in which each of contents of the elements in the alloy was in the range defined by the scope of the present invention; the ratios between each of elements in the alloy were in the range defined by the scope of the present invention; and the special grain boundary length ratio (Lσ/L), which is the ratio between Lσ and L, was in the range defined by the scope of the present invention based on the structure observation results. Lσ is the sum of each grain boundary length of: Σ3; Σ9; Σ27a; and Σ27b special grain boundaries; and L is the length of all crystal grain boundaries. In these samples, the yield strength and bendability were excellent too. Thus, applicability of the alloy to terminal parts such as connectors or the like was sufficiently confirmed.

On the contrary, as shown in Table 6, in Comparative Examples No. 50 to 57, the stress relaxation resistance or bendability was inferior to Examples of the present invention.

Comparative Example No. 50 was the Cu-30Zn alloy and the stress relaxation resistance of the coper alloy was inferior.

In addition, in Comparative Example No. 51, the special grain boundary length ratio (Lσ/L), which is the ratio between the sum of each grain boundary length of: $\Sigma 3$; $\Sigma 9$; $\Sigma 27a$; and $\Sigma 27b$ special grain boundaries (Lσ) and the length of all crystal grain boundaries (L), was 8% and out of the range defined by the scope of the present invention; and its bendability was inferior.

Comparative Example No. 52 was the Cu-20Zn alloy in which Sn was over-dozed without addition of Ni, Fe, P, and Co. In this Comparative Example No. 52, the stress relaxation resistance of the copper alloy was inferior compared to Examples of the present invention based on the Cu-20Zn alloy.

Comparative Example No. 53 was the Cu-20Zn alloy in which Sn, Fe, P, and Co were not added. In this Comparative Example No. 53, the stress relaxation resistance of the copper alloy was inferior compared to Examples of the present invention based on the Cu-20Zn alloy.

Comparative Example No. 54 was the Cu-15Zn alloy, in which Sn, Ni, Fe, and Co were not added; and the average grain size was coarse. In this Comparative Example No. 54, the yield strength and the stress relaxation resistance were inferior compared to Examples of the present invention based on the Cu-15Zn alloy.

Comparative Example No. 55 was the Cu-15Zn alloy, in which Ni was not added; and the contents of Fe and P were out of the range defined by the scope of the present invention. In this Comparative Example No. 55, the stress relaxation resistance was inferior compared to Examples of the present invention based on the Cu-15Zn alloy.

Comparative Example No. 56 was the Cu-15Zn alloy, in which Fe and Co were not added. In this Comparative Example No. 56, not only the yield strength but the stress relaxation resistance was inferior compared to Examples of the present invention based on the Cu-15Zn alloy.

Comparative Example No. 57 was the Cu-5Zn alloy, in which the average grain size was coarse. In this Comparative Example No. 57, the yield strength and the stress relaxation resistance were inferior compared to Examples of the present invention based on the Cu-5Zn alloy.

INDUSTRIAL APPLICABILITY

A conductive component for an electric and electronic device and a terminal, in which the residual stress is not relaxed easily and is capable of retaining the contact pressure to the opposite-side conductive part over time or under a high temperature environment, are provided. In addition, the thickness of the conductive component for an electric and electronic device and the terminal is decreased.

**Claims**

1. A copper alloy for an electric and electronic device, the copper alloy comprising:

    Zn at higher than 2 mass% and lower than 23 mass%;
    Sn at 0.1 mass% or more and 0.9 mass% or less;
    Ni at 0.05 mass% or more and lower than 1.0 mass%;
    Fe at 0.001 mass% or more and 0.08 mass% or less;
    P at 0.005 mass% or more and 0.1 mass% or less;
    optionally Co at 0.001 mass% or more and lower than 0.1 mass%; and
    the balance being Cu and unavoidable impurities,
    wherein a ratio (Fe+Co)/Ni of a total content of (Fe+Co) of Fe and Co to a Ni content satisfies $0.002 \leq (Fe+Co)/Ni < 1.5$ by atomic ratio,
    a ratio (Ni+Fe+Co)/P of a total content (Ni+Fe+Co) of Ni, Fe, and Co to a P content satisfies $3 < (Ni+Fe+Co)/P < 15$ by atomic ratio,
    a ratio Sn/(Ni+Fe+Co) of a Sn content to the total content (Ni+Fe+Co) of Ni, Fe, and Co satisfies $0.3 < Sn/(Ni+Fe+Co) < 5$ by atomic ratio, and
    a special grain boundary length ratio, Lσ/L, is 10% or more, Lσ/L being a ratio of Lσ to L, Lσ being a sum of each grain boundary length of: $\Sigma 3$; $\Sigma 9$; $\Sigma 27a$; and $\Sigma 27b$ special grain boundaries in $\alpha$ phase crystal grains wherein the $\Sigma$ value is defined based on the CSL theory, and L being a length of all crystal grain boundaries in $\alpha$ phase crystal grains, in a case where an $\alpha$ phase containing Cu, Zn and Sn within a measurement area of 1000 $\mu m^2$ or larger is measured by EBSD method with a measurement interval of 0.1 $\mu m$ a step; data analysis is performed excluding measurement points with a CI (confidence index) value at 0.1 or less, the CI value being analyzed by a data analysis software OIM (orientation imaging microscopy); and a grain boundary is identified between adjacent measurement points with a misorientation exceeding 15°.

**2.** The copper alloy for an electric and electronic device according to claim 1, which contains Co at 0.001 mass% or more and lower than 0.1 mass%.

**3.** The copper alloy for an electric and electronic device according to claim 1 or 2, wherein an average crystal grain size of the $\alpha$ phase containing Cu, Zn and Sn including twinned crystals is in a range of 0.5 $\mu$m or more and 10 $\mu$m or less.

**4.** The copper alloy for an electric and electronic device according to any one of claims 1 to 3, wherein the copper alloy has mechanical properties including a 0.2% yield strength of 300 MPa or higher.

**5.** A copper alloy sheet for an electric and electronic device comprising a rolled material formed of the copper alloy for an electric and electronic device according to any one of claims 1 to 4, wherein a thickness of the copper alloy sheet is in a range of 0.05 mm to 1.0 mm.

**6.** The copper alloy sheet for an electric and electronic device according to claim 5, wherein Sn is plated on a surface of the copper alloy sheet.

**7.** A conductive component for an electric and electronic device comprising the copper alloy for an electric and electronic device according to any one of claims 1 to 4 or the copper alloy sheet for an electric and electronic device according to claim 5 or 6.

**8.** A terminal comprising the copper alloy for an electric and electronic device according to any one of claims 1 to 4 or the copper alloy sheet for an electric and electronic device according to claim 5 or 6.

**Patentansprüche**

**1.** Kupferlegierung für eine elektrische und elektronische Vorrichtung, wobei die Kupferlegierung umfasst:

Zn zu höher als 2 Masse-% und niedriger als 23 Masse-%,
Sn zu 0,1 Masse-% oder mehr und 0,9 Masse-% oder weniger,
Ni zu 0,05 Masse-% oder mehr und niedriger als 1,0 Masse-%,
Fe zu 0,001 Masse-% oder mehr und 0,08 Masse-% oder weniger,
P zu 0,005 Masse-% oder mehr und 0,1 Masse-% oder weniger,
gegebenenfalls Co zu 0,001 Masse-% oder mehr und niedriger als 0,1 Masse-% und
den Rest, der Cu und unvermeidliche Verunreinigungen ist,
wobei ein Verhältnis (Fe+Co)/Ni eines (Fe+Co)-Gesamtgehalts aus Fe und Co zu einem Ni-Gehalt $0,002 \leq (Fe+Co)/Ni < 1,5$ als Atomverhältnis erfüllt,
ein Verhältnis (Ni+Fe+Co)/P eines (Ni+Fe+Co)-Gesamtgehalts aus Ni, Fe und Co zu einem P-Gehalt $3 < (Ni+Fe+Co)/P < 15$ als Atomverhältnis erfüllt,
ein Verhältnis Sn/(Ni+Fe+Co) von einem Sn-Gehalt zu einem (Ni+Fe+Co)-Gesamtgehalt aus Ni, Fe und Co $0,3 < Sn/(Ni+Fe+Co) < 5$ als Atomverhältnis erfüllt und
ein spezielles Korngrenzenlängenverhältnis L$\sigma$/L 10 % oder mehr beträgt, wobei L$\sigma$/L ein Verhältnis von L$\sigma$ zu L ist, wobei L$\sigma$ eine Summe von jeder Korngrenzenlänge von speziellen $\Sigma$3-, $\Sigma$9-, $\Sigma$27a- und $\Sigma$27b- Korngrenzen in $\alpha$-Phasenkristallkörnern ist, wobei der $\Sigma$-Wert basierend auf der CSL-Theorie definiert ist und L eine Länge von allen Kristallkorngrenzen in $\alpha$-Phasenkristallkörnern ist, wenn eine $\alpha$-Phase, die Cu, Zn und Sn enthält, innerhalb einer Messfläche von 1.000 $\mu$m$^2$ oder größer durch ein EBSD-Verfahren mit einem Messintervall von 0,1 $\mu$m pro Schritt gemessen wird, die Datenanalyse mit Ausnahme von Messpunkten mit einem CI (Konfidenzindex)-Wert von 0,1 oder weniger durchgeführt wird, wobei der CI-Wert durch eine Datenanalyse-Software OIM (Orientierungsmikroskopie) analysiert wird, und eine Korngrenze zwischen nebeneinanderliegenden Messpunkten mit einer Fehlorientierung, die 15° übersteigt, identifiziert wird.

**2.** Kupferlegierung für eine elektrische und elektronische Vorrichtung gemäß Anspruch 1, die Co zu 0,001 Masse-% oder mehr und niedriger als 0,1 Masse-% enthält.

**3.** Kupferlegierung für eine elektrische und elektronische Vorrichtung gemäß Anspruch 1 oder 2, wobei eine durchschnittliche Kristallkorngröße der $\alpha$-Phase, die Cu, Zn und Sn enthält, einschließlich verzwillingter Kristalle in einem Bereich von 0,5 $\mu$m oder mehr und 10 $\mu$m oder weniger liegt.

4. Kupferlegierung für eine elektrische und elektronische Vorrichtung gemäß irgendeinem der Ansprüche 1 bis 3, wobei die Kupferlegierung mechanische Eigenschaften einschließlich einer 0,2 %-Dehngrenze von 300 MPa oder höher aufweist.

5. Kupferlegierungsblech für eine elektrische und elektronische Vorrichtung, umfassend ein gewalztes Material, das aus der Kupferlegierung für eine elektrische und elektronische Vorrichtung gemäß irgendeinem der Ansprüche 1 bis 4 gebildet ist,
wobei eine Dicke des Kupferlegierungsblechs in einem Bereich von 0,05 mm bis 1,0 mm liegt.

6. Kupferlegierungsblech für eine elektrische und elektronische Vorrichtung gemäß Anspruch 5, wobei Sn auf einer Oberfläche des Kupferlegierungsblechs plattiert ist.

7. Leitfähige Komponente für eine elektrische und elektronische Vorrichtung, umfassend die Kupferlegierung für eine elektrische und elektronische Vorrichtung gemäß irgendeinem der Ansprüche 1 bis 4 oder das Kupferlegierungsblech für eine elektrische und elektronische Vorrichtung gemäß Anspruch 5 oder 6.

8. Klemme, umfassend die Kupferlegierung für eine elektrische und elektronische Vorrichtung gemäß irgendeinem der Ansprüche 1 bis 4 oder das Kupferlegierungsblech für eine elektrische und elektronische Vorrichtung gemäß Anspruch 5 oder 6.

**Revendications**

1. Alliage de cuivre pour un dispositif électrique et électronique, l'alliage de cuivre comprenant :

plus de 2 % en masse et moins de 23 % en masse de Zn ;
au moins 0,1 % en masse et au plus 0,9 % en masse de Sn ;
au moins 0,05 % en masse et au plus 1,0 % en masse de Ni ;
au moins 0,001 % en masse et au plus 0,08 % en masse de Fe ;
au moins 0,005 % en masse et au plus 0,1 % en masse de P ;
éventuellement au moins 0,001 % en masse et au plus 0,1 % en masse de Co ; et
le reste étant du Cu et des impuretés inévitables,
dans lequel un rapport (Fe+Co)/Ni entre une teneur totale (Fe+Co) en Fe et en Co et une teneur en Ni satisfait à $0,002 \leq (Fe+Co)/Ni < 1,5$ en rapport atomique,
un rapport (Ni+Fe+Co)/P entre une teneur totale (Ni+Fe+Co) en Ni, en Fe et en Co et une teneur en P satisfait à $3 < (Ni+Fe+Co)/P < 15$ en rapport atomique,
un rapport Sn/(Ni+Fe+Co) entre une teneur en Sn et la teneur totale (Ni+Fe+Co) en Ni, en Fe et en Co satisfait à $0,3 < Sn/(Ni+Fe+Co) < 5$ en rapport atomique, et
un rapport de longueur des joints de grain spécial, $L\sigma/L$, est supérieur ou égal à 10 %, $L\sigma/L$ étant un rapport entre $L\sigma$ et L, $L\sigma$ étant une somme de chaque longueur de joint de grain de: joints de grain spéciaux $\Sigma 3$; $\Sigma 9$; $\Sigma 27a$ ; et $\Sigma 27b$ dans des grains cristallins de phase $\alpha$ dans lequel la valeur $\Sigma$ est définie sur la base de la théorie CSL, et L étant une longueur de tous les joints de grain cristallin dans des grains cristallins de phase $\alpha$, dans un cas où une phase $\alpha$ contenant Cu, Zn et Sn à l'intérieur d'une zone de mesure supérieure ou égale à 1000 $\mu m^2$ est mesurée par un procédé EBSD avec un intervalle de mesure de 0,1 $\mu m$ par étape ; une analyse des données est réalisée en excluant des points de mesure avec une valeur de CI (indice de confiance) inférieure ou égale à 0,1, la valeur de CI étant analysée par une OIM (microscopie à imagerie orientée) à logiciel d'analyse de données ; et un joint de grain est identifié entre des points de mesure adjacents avec un défaut d'orientation dépassant les 15°.

2. Alliage de cuivre pour un dispositif électrique et électronique selon la revendication 1, qui contient au moins 0,001 % en masse et au plus 0,1 % en masse de Co.

3. Alliage de cuivre pour un dispositif électrique et électronique selon la revendication 1 ou 2, dans lequel une taille de grain cristallin moyenne de la phase $\alpha$ contenant Cu, Zn et Sn incluant des cristaux maclés se situe dans une plage d'au moins 0,5 $\mu m$ et d'au plus 10 $\mu m$.

4. Alliage de cuivre pour un dispositif électrique et électronique selon l'une quelconque des revendications 1 à 3, dans lequel l'alliage de cuivre a des propriétés mécaniques incluant une limite d'élasticité à 0,2 % supérieure ou égale à 300 MPa.

5.  Feuille d'alliage de cuivre pour un dispositif électrique et électronique comprenant un matériau laminé composé de l'alliage de cuivre pour un dispositif électrique et électronique selon l'une quelconque des revendications 1 à 4, dans laquelle une épaisseur de la feuille d'alliage de cuivre se situe dans une plage de 0,05 mm à 1,0 mm.

6.  Feuille d'alliage de cuivre pour un dispositif électrique et électronique selon la revendication 5, dans laquelle du Sn est plaqué sur une surface de la feuille d'alliage de cuivre.

7.  Composant conducteur pour un dispositif électrique et électronique comprenant l'alliage de cuivre pour un dispositif électrique et électronique selon l'une quelconque des revendications 1 à 4, ou feuille d'alliage de cuivre pour un dispositif électrique et électronique selon la revendication 5 ou 6.

8.  Terminal comprenant l'alliage de cuivre pour un dispositif électrique et électronique selon l'une quelconque des revendications 1 à 4, ou feuille d'alliage de cuivre pour un dispositif électrique et électronique selon la revendication 5 ou 6.

FIG. 1

```
┌─────────────────────┐
│  MELT CASTING STEP  │────── S01
└─────────────────────┘
           │
           ▼
┌─────────────────────┐
│       INGOT         │
└─────────────────────┘
           │
           ▼
┌─────────────────────┐
│    HEATING STEP     │────── S02
└─────────────────────┘
           │         │
           │         ▼
           │   ┌──────────────┐
           │   │ HOT WORKING  │────── S03
           │   │    STEP      │
           │   └──────────────┘
           │         │
           ▼         ▼
┌─────────────────────┐
│    INTERMEDIATE     │────── S04
│ PLASTIC WORKING STEP│
└─────────────────────┘
           │
           ▼
┌─────────────────────┐
│ INTERMEDIATE HEAT   │────── S05
│  TREATMENT STEP     │
└─────────────────────┘
           │
           ▼
    ┌──────────────┐
    │ FINISH PLASTIC│────── S06
    │ WORKING STEP │
    └──────────────┘
           │
           ▼
    ┌──────────────┐
    │ FINISH HEAT  │────── S07
    │TREATMENT STEP│
    └──────────────┘
           │
           ▼
┌─────────────────────┐
│  COPPER ALLOY FOR   │
│    ELECTRIC AND     │
│  ELECTRONIC DEVICE  │
└─────────────────────┘
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013055076 A
- JP H533087 A
- JP 2006283060 A
- JP 3953357 B
- JP 3717321 B
- US 6471792 B1

### Non-patent literature cited in the description

- **J. M. ANDRADE.** *Spectrochimica Acta.,* 2010, vol. 65 (8), 658-663
- **SEIICHI SUZUKI.** EBSD Reader: Using OIM. TSL Solutions Co., Ltd, September 2009
- **KRONBERG et al.** *Trans. Met. Soc. AIME,* 1949, vol. 185, 501
- **D. G. BRANDON.** *Acta. Metallurgica,* 1966, vol. 14, 1479